# EUROPÄISCHE PATENTSCHRIFT

(11) **EP 3 449 216 B1**
(45) Veröffentlichungstag und Bekanntmachung des Hinweises auf die Patenterteilung: **09.09.2020**
(21) Anmeldenummer: 16731024.2
(22) Anmeldetag: 29.04.2016
(51) Int. Cl.: G01D 5/14

(54) **ABSTANDSMESSVORRICHTUNG**
DISTANCE-MEASURING DEVICE
DISPOSITIF DE MESURE DE DISTANCE

(43) Veröffentlichungstag der Anmeldung: 06.03.2019
(60) Teilanmeldung: 19000252.7
(73) Patentinhaber: TDK-Micronas GmbH, 79108 Freiburg (DE)
(72) Erfinder: FRANKE, Jörg, 79117 Freiburg (DE)
(74) Vertreter: Koch Müller Patentanwaltsgesellschaft mbH
(86) Internationale Anmeldenummer: PCT/EP2016/000693
(87) Internationale Veröffentlichungsnummer: WO 2017/186256

(56) Entgegenhaltungen:
- EP-A1- 1 477 772
- DE-A1- 19 941 860
- DE-A1- 19 941 860
- DE-A1-102004 046 824
- DE-A1-102004 046 824
- DE-A1-102014 003 408
- DE-A1-102014 003 408

## Beschreibung

Aus der DE 10 2015 013 022 A1 ist eine Magnetfeldmessvorrichtung bekannt. Weitere auf Magnetfeldmesssensoren basierende Messvorrichtungen sind aus der DE 10 2014 003 408 A1, der DE 199 41 860 A1, der EP 1 477 772 A1 und der DE 10 2004 046 824 A1 bekannt.

Vor diesem Hintergrund besteht die Aufgabe der Erfindung darin, eine Vorrichtung anzugeben, die den Stand der Technik weiterbildet.

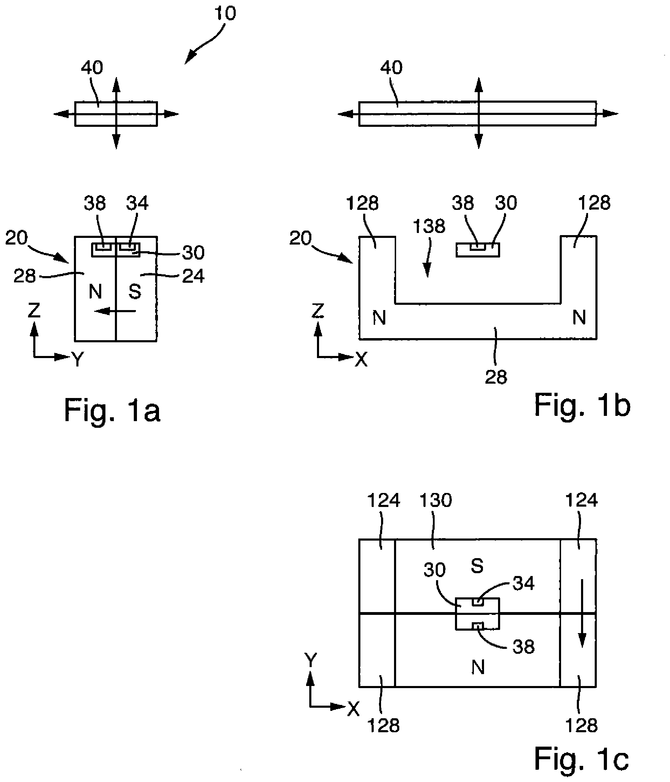

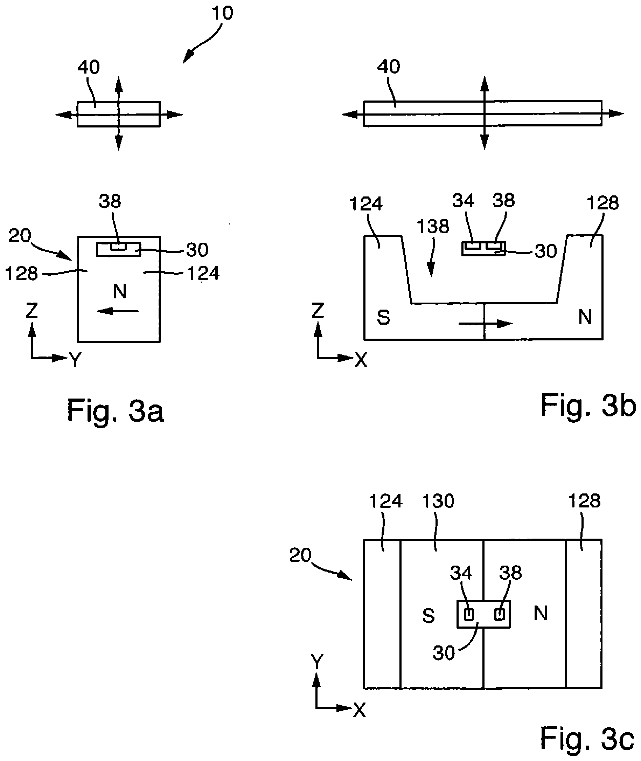

Abbildungen 1, 2 bis 5 zeigen Ausführungsbeispiele der Erfindung. Abbildungen 3, 4 und 6-17 zeigen weitere Beispiele, die nicht unter den Schutzbereich der Erfindung fallen, auch wenn sie in den zugehörigen Passagen der Beschreibung als "Ausführungsbeispiele" bezeichnet werden.

Der Schutzbereich der Erfindung wird durch die Ansprüche definiert.

Die Aufgabe wird durch eine Abstandsmessvorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Abstandsmessvorrichtung bereitgestellt, wobei die Abstandsmessvorrichtung einen ersten Magnetfeldsensor aufweist, wobei der Magnetfeldsensor ein erstes Messsignal in Abhängigkeit der Stärke des Magnetfelds bereitstellt und die Abstandsmessvorrichtung wenigstens einen Dauermagneten aufweist.

Der Dauermagnet weist einen ersten magnetischen Pol mit einer ersten Polfläche und einen zweiten magnetischen Pol mit einer zweiten Polfläche auf.

Vorgesehen ist auch ein Halbleiterkörper mit einer monolithisch intergierten Auswerteschaltung, wobei die Auswerteschaltung in einer elektrischen Wirkverbindung mit dem ersten Magnetfeldsensor steht und der Halblelter-körper eine in der X-Y Ebene ausgebildete Oberfläche aufweist.

Weiterhin ist ein auf dem gleichen physikalischen Wirkprinzip wie der erste Magnetfeldsensor beruhender zweiter Magnetfeldsensor vorgesehen, wobei der zweite Magnetfeldsensor ein zweites Messsignal in Abhängigkeit der Stärke des Magnetfelds zur Verfügung stellt und der zweite Magnetfeldsensor in einer Wirkverbindung mit der Auswerteschaltung steht.

Die Auswerteschaltung ermittelt zur Unterdrückung von magnetischen Gleichfeldern ein Differenzsignal und stellt ein Ausgangssignal als Ergebnis der Ermittlung bereit, wobei der Wert des auf der Aufhebung eines magnetflussfreien Bereichs beruhenden Ausgangssignals von einem Abstand eines ferromagnetischen Gebers zu den beiden Magnetfeldsensoren abhängt.

Die beiden Magnetfeldsensoren sind kraftschlüssig mit der Oberfläche des Halbleiterkörpers verbunden und um die gleiche Komponente des Magnetfeldes zu messen, im Wesentlich oder genau gleich angeordnet.

In einer ersten Ausführungsform ist, um die Größe der Flussänderung bei einem auf beide Halbleitersensoren gleich stark einwirkenden ersten Geber zu messen, der Halbleiterkörper zwischen u-förmig ausgebildeten Polschenkeln des in Y-Richtung magnetisierten Magneten angeordnet.

Der erste Magnetfeldsensor ist hierbei in einem zwischen zwei einander gegenüberliegenden Schenkeln des ersten Pols liegendem Gebiet angeordnet, während der zweite Magnetfeldsensor in einem zwischen zwei einander gegenüberliegenden Schenkeln des zweiten Pols liegendem Gebiet angeordnet ist.

Zwischen den Polschenkeln ist eine Bodenfläche ausgebildet und der Halbleiterkörper ist in Z-Richtung oberhalb des Bodenbereichs angeordnet.

in einer zweiten Ausführungsform ist, um die Größe der Flussänderung bei einem auf beide Halbleitersensoren unterschiedlich stark einwirkenden zweiten Geber zu messen, der Dauermagnet in Z-Richtung magnetisiert.

Eine der beiden Polflächen ist in der X-Y Ebene ausbildet und die Magnetfeldsensoren sind entlang der wenigstens einen Polfläche angeordnet.

Es versteht sich, dass der erste Pol des Dauermagneten als Nordpol und der zweite Pol als Südpol oder vice versa ausgebildet ist. Bevorzugt ist zwar, dass der Dauermagnet einstückig ausgebildet ist, jedoch lassen sich in einigen der nachfolgenden Weiterbildungen auch zwei einzelne oder mehrere einzelne Dauermagnete vorteilhaft verwenden.

Es sei angemerkt, dass in der ersten Ausführungsform unter dem Begriff des gleichstark einwirkenden Gebers, ein sogenannter symmetrischer Geber verstanden wird. Vorzugsweise sind derartige Geber plattenförmig ausgebildet, wobei die Größe der Platte insbesondere größer als der Abstand zwischen den beiden Magnetfeldsensoren ist. Der Geber weist einen gleichen Abstand zu den beiden Magnetfeldsensoren auf, d.h. bei einer Veränderung des Abstandes erfolgen die Veränderungen zu beiden Magnetfeldsensoren gleichmäßig.

In der zweiten Ausführungsform wird unter dem Begriff des unterschiedlich stark einwirkenden Gebers ein sogenannter unsymmetrischer Geber verstanden. Hierbei ist der Abstand des Gebers zu den beiden Magnetfeldsensoren immer unterschiedlich.

Weiter sei angemerkt, dass für beide Ausführungsformen der Halbleiterkörper die beiden Magnetfeldsensoren derart in Bezug zu einem der Pole oder zu beiden Polen angeordnet sind, dass die Sensoren ohne Geber kein Magnetfeld sehen, d.h. keine Messsignal erzeugen. Anders ausgedrückt sind die beiden Magnetfeldsensoren so positioniert, dass für diejenigen Komponenten des Magnetfeldes für welche die beiden Magnetfeldsensoren empfindlich sind im Wesentlichen fast Null oder vorzugsweise so klein sind, dass die Magnetfeldsensoren die Komponenten nicht detektierbar sind. Anders ausgerückt sind die beiden Magnetfeldsensoren vorzugsweise genau in einem magnetflussfreien Bereich angeordnet. Indem ein ferromagnetischer Geber sich nähert, beruht dann das Messsignal und das Ausgangssignal letztlich auf der Aufhebung des magnetflussfreien Bereichs, wenigstens der einen messbaren Komponente des Magnetfeldes.

Es versteht sich, dass bei einer Verwendung von sogenannten 3D-Magnetfeldsensoren, welche alle drei Komponenten des Magnetfeldes erfassen, sich der magnetflussfreie Bereich sich auf alle drei Komponenten bezieht.

Ein Vorteil der erfindungsgemäßen Vorrichtung ist es, dass durch die Anordnung von zwei Magnetfeldsensoren mittels der Ermittlung des Differenzsignals magnetischer Gleichfelder sich ausblenden lassen. Des Weiteren vergrößert sich der Signalhub und die Zuverlässigkeit der Abstandsbestimmung wird erhöht.

In einer Weiterbildung ist der Dauermagnet u-förmig ausgebildet und weist zwei einander gegenüberliegende gerade und parallel verlaufende Schenkel oder kreisförmige Schenkel auf. In der ersten Ausführungsform wechselt dabei die Polarität des Magnetfeldes in Richtung senkrecht zu der Z-Achse, während in der zweiten Ausführungsform der Bodenbereich des Magneten insgesamt eine andere Polarität als der gesamte Schenkelbereich aufweist.

In einer anderen Weiterbildung weist der Dauermagnet in einem zentralen Bereich eine Aussparung auf. Vorzugsweise ist Aussparung lochförmig ausgebildet ist, wobei die lochförmige Aussparung sowohl kreisförmig als auch viereckig vorzugsweise rechteckig ausgebildet ist. Untersuchungen haben gezeigt, dass durch die Aussparung sich der der Nullfeldbereich vergrößern lässt. Vorzugsweise umfasst der zentrale Bereich mit der Aussparung den Schwerpunkt des Dauermagneten.

In einer Ausführungsform ist der Halbleiterkörper oberhalb des Schwerpunkts des Dauermagneten angeordnet, so dass die an der Stelle des Schwerpunkts des Dauermagneten ausgebildete Normale den Halbleiterkörper durchdringt.

in einer anderen Ausführungsform besteht der Dauermagnet in der ersten Alternative aus zwei entgegengesetzt unmittelbar nebeneinander angeordneten vertikal magnetisierten Einzelmagneten gebildet. Der Dauermagnet ist anstelle von bisher einstückig nunmehr zweistückig ausgebildet.

In einer Weiterbildung ist zwischen den Schenkeln ein Bodenbereich ausgebildet, wobei bei der ersten Alternative entlang der Mittellinie im Bereich des Bodens die Polarität des Magneten wechselt und bei der zweiten Alternative die Polarität im Bereich des Bodens des Magneten gleich bleibt.

In einer Ausführungsform bilden die Schenkel in der X-Y-Ebene einen umlaufenden Wall aus. Bei der ersten Alternative weist eine erste Hälfte des Walls die erste magnetische Polarität und eine zweite Hälfte des Walls die zweite Polarität auf. Hierbei ist der erste Magnetfeldsensor in dem Bereich der ersten magnetischen Polarität und der zweite Magnetfeldsensor in dem Bereich der zweiten magnetischen Polarität angeordnet. Bei der zweiten Alternative weist der umlaufende Wall eine einheitliche magnetische Polarität auf, d.h. beide Magnetfeldsensoren sind in dem Bereich entweder der ersten Polarität oder der zweiten Polarität angeordnet.

In einer anderen Ausführungsform weisen die in der X-Y-Ebene angeordneten Oberflächen der beiden Magnetfeldsensoren in Bezug auf die Z-Richtung einen gleichen oder geringeren Abstand zu der inneren Bodenfläche des Magneten auf, als die an den Enden der Schenkel ausgebildete Polflächen. Anders ausgedrückt, die Oberfläche der Magnetfeldsensoren ist maximal auf der gleichen Höhe bevorzugt jedoch etwas tiefer als die Polflächen.

In einer Ausführungsform weisen die beiden Magnetfeldsensoren zu der jeweiligen unmittelbar benachbarten Polfläche den gleichen Abstand auf, d.h. der Abstand in der X-Richtung und / oder in der Y-Richtung zu den jeweils unmittelbar benachbarten Polflächen ist gleich.

In einer Weiterbildung sind bei der zweiten Alternative die beiden Magnetfeldsensoren in der X-Richtung zu der einzigen entlang der Y-Richtung ausgebildeten Polfläche beabstandet.

In einer anderen Weiterbildung sind bei der zweiten Alternative die beiden Magnetfeldsensoren entlang der X-Richtung angeordnet sind und zwischen den in X-Richtung beiden voneinander beabstandeten Dauermagneten angeordnet sind.

In einer Weiterbildung sind die beiden Magnetfeldsensoren als Hallsensoren ausgebildet und vorzugsweise monolithisch in den Halbleiterkörper sind. In einer Ausführungsform sind die Hallsensoren als in der X-Y-Ebene ausgebildete Hallplatten ausgeführt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1a: eine Draufsicht auf eine erste erfindungsgemäße Ausführungsform in einer Ansicht in der Y-Z-Ebene,
- Figur 1b: eine Draufsicht auf die erste erfindungsgemäße Ausführungsform in einer Ansicht in der X-Z-Ebene,
- Figur 1c: eine Draufsicht auf die erste erfindungsgemäße Ausführungsform in einer Ansicht in der X-Y-Ebene,
- Figur 2a: eine Draufsicht auf eine zweite erfindungsgemäße Ausführungsform in einer Ansicht in der Y-Z-Ebene,
- Figur 2b: eine Draufsicht auf die zweite erfindungsgemäße Ausführungsform in einer Ansicht in der X-Z-Ebene,
- Figur 2c: eine Draufsicht auf die zweite erfindungsgemäße Ausführungsform in einer Ansicht in der X-Y-Ebene,
- Figur 3a: eine Draufsicht auf eine dritte erfindungsgemäße Ausführungsform in einer Ansicht in der Y-Z-Ebene,
- Figur 3b: eine Draufsicht auf die dritte erfindungsgemäße Ausführungsform in einer Ansicht in der X-Z-Ebene,
- Figur 3c: eine Draufsicht auf die dritte erfindungsgemäße Ausführungsform in einer Ansicht in der X-Y-Ebene,
- Figur 4a: eine Draufsicht auf eine vierte erfindungsgemäße Ausführungsform in einer Ansicht in der Y-Z-Ebene,
- Figur 4b: eine Draufsicht auf die vierte erfindungsgemäße Ausführungsform in einer Ansicht in der X-Z-Ebene,
- Figur 4c: eine Draufsicht auf die vierte erfindungsgemäße Ausführungsform in einer Ansicht in der X-Y-Ebene,
- Figur 5a: eine Draufsicht auf eine fünfte erfindungsgemäße Ausführungsform in einer Ansicht in der Y-Z-Ebene,
- Figur 5b: eine Draufsicht auf die fünfte erfindungsgemäße Ausführungsform in einer Ansicht in der X-Z-Ebene,
- Figur 5c: eine Draufsicht auf die fünfte erfindungsgemäße Ausführungsform in einer Ansicht in der X-Y-Ebene,
- Figur 6a: eine Draufsicht auf eine sechste erfindungsgemäße Ausführungsform in einer Ansicht in der Y-Z-Ebene,
- Figur 6b: eine Draufsicht auf die sechste erfindungsgemäße Ausführungsform in einer Ansicht in der X-Z-Ebene,
- Figur 6c: eine Draufsicht auf die sechste erfindungsgemäße Ausführungsform in einer Ansicht in der X-Y-Ebene,
- Figur 7a: eine Draufsicht auf eine siebte erfindungsgemäße Ausführungsform in einer Ansicht in der Y-Z-Ebene,
- Figur 7b: eine Draufsicht auf die siebte erfindungsgemäße Ausführungsform in einer Ansicht in der X-Z-Ebene,
- Figur 7c: eine Draufsicht auf die siebte erfindungsgemäße Ausführungsform in einer Ansicht in der X-Y-Ebene,
- Figur 8a: eine Draufsicht auf eine achte erfindungsgemäße Ausführungsform in einer Ansicht in der Y-Z-Ebene,
- Figur 8b: eine Draufsicht auf die achte erfindungsgemäße Ausführungsform in einer Ansicht in der X-Z-Ebene,
- Figur 8c: eine Draufsicht auf die achte erfindungsgemäße Ausführungsform in einer Ansicht in der X-Y-Ebene,
- Figur 9a: eine Draufsicht auf eine neunte erfindungsgemäße Ausführungsform in einer Ansicht in der Y-Z-Ebene,
- Figur 9b: eine Draufsicht auf die neunte erfindungsgemäße Ausführungsform in einer Ansicht in der X-Z-Ebene,
- Figur 9c: eine Draufsicht auf die neunte erfindungsgemäße Ausführungsform in einer Ansicht in der X-Y-Ebene,
- Figur 10a: eine Draufsicht auf eine zehnte erfindungsgemäße Ausführungsform in einer Ansicht in der Y-Z-Ebene,
- Figur 10b: eine Draufsicht auf die zehnte erfindungsgemäße Ausführungsform in einer Ansicht in der X-Z-Ebene,
- Figur 10c: eine Draufsicht auf die zehnte erfindungsgemäße Ausführungsform in einer Ansicht in der X-Y-Ebene,
- Figur 11a: eine Draufsicht auf eine elfte erfindungsgemäße Ausführungsform in einer Ansicht in der Y-Z-Ebene,
- Figur 11b: eine Draufsicht auf die elfte erfindungsgemäße Ausführungsform in einer Ansicht in der X-Z-Ebene,
- Figur 11c: eine Draufsicht auf die elfte erfindungsgemäße Ausführungsform in einer Ansicht in der X-Y-Ebene,
- Figur 12a: eine Draufsicht auf eine zwölfte erfindungsgemäße Ausführungsform in einer Ansicht in der Y-Z-Ebene,
- Figur 12b: eine Draufsicht auf die zwölfte erfindungsgemäße Ausführungsform in einer Ansicht in der X-Z-Ebene,
- Figur 12c: eine Draufsicht auf die zwölfte erfindungsgemäße Ausführungsform in einer Ansicht in der X-Y-Ebene,
- Figur 13a: eine Draufsicht auf eine dreizehnte erfindungsgemäße Ausführungsform in einer Ansicht in der Y-Z-Ebene,
- Figur 13b: eine Draufsicht auf die dreizehnte erfindungsgemäße Ausführungsform in einer Ansicht in der X-Z-Ebene,
- Figur 13c: eine Draufsicht auf die dreizehnte erfindungsgemäße Ausführungsform in einer Ansicht in der X-Y-Ebene,
- Figur 14a: eine Draufsicht auf eine vierzehnte erfindungsgemäße Ausführungsform in einer Ansicht in der Y-Z-Ebene,
- Figur 14b: eine Draufsicht auf die vierzehnte erfindungsgemäße Ausführungsform in einer Ansicht in der X-Z-Ebene,
- Figur 14c: eine Draufsicht auf die vierzehnte erfindungsgemäße Ausführungsform in einer Ansicht in der X-Y-Ebene,
- Figur 15a: eine Draufsicht auf eine fünfzehnte erfindungsgemäße Ausführungsform in einer Ansicht in der Y-Z-Ebene,
- Figur 15b: eine Draufsicht auf die fünfzehnte erfindungsgemäße Ausführungsform in einer Ansicht in der X-Z-Ebene,
- Figur 15c: eine Draufsicht auf die fünfzehnte erfindungsgemäße Ausführungsform in einer Ansicht in der X-Y-Ebene,
- Figur 16a: eine Draufsicht auf eine sechzehnte erfindungsgemäße Ausführungsform in einer Ansicht in der Y-Z-Ebene,
- Figur 16b: eine Draufsicht auf die sechzehnte erfindungsgemäße Ausführungsform in einer Ansicht in der X-Z-Ebene,
- Figur 16c: eine Draufsicht auf die sechzehnte erfindungsgemäße Ausführungsform in einer Ansicht in der X-Y-Ebene,
- Figur 17a: eine Draufsicht auf eine siebzehnte erfindungsgemäße Ausführungsform in einer Ansicht In der Y-Z-Ebene,
- Figur 17b: eine Draufsicht auf die siebzehnte erfindungsgemäße Ausführungsform in einer Ansicht in der X-Z-Ebene,
- Figur 17c: eine Draufsicht auf die siebzehnte erfindungsgemäße Ausführungsform in einer Ansicht in der X-Y-Ebene.

Für alle nachfolgenden Ausführungsformen wird folgendes angemerkt, zur Veranschaulichung ist jeweils nur eine ausgewählte Magnetisierungsrichtung eingezeichnet. Es versteht sich aber, dass die Magnetisierungsrichtung bei allen dargestellten Ausführungsbeispielen auch genau um 180° d.h. entgegengesetzt zu der jeweils dargestellten Richtung ausgebildet sein kann, unter Beibehaltung der weiteren geometrischen Anordnung und insbesondere der Ausrichtung des Halbleiterkörpers mit den beiden Magnetfeldsensoren an der Oberfläche.

Die Abbildung der Figur 1a zeigt eine Draufsicht auf eine erste erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung. entgegengesetzt zur Y-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Die beiden Magnetfeldsensoren 34 und 38 sind in der Y-Richtung voneinander beabstandet. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist.

In der Abbildung der Figur 1b ist eine Draufsicht auf die erste erfindungsgemäße Ausführungsform in einer Ansicht in der X-Z-Ebene dargestellt. Im Folgenden werden nur die Unterschiede zu der Figur 1a erläutert.

Der Dauermagnat 20 weist als Nordpol 28 zwei in der X-Richtung beabstandete Schenkel 128 auf. Zwischen den Schenkeln 128 des Nordpols 28 ist ein Bodenbereich 130 ebenfalls als Nordpol 28 ausgebildet. Hierdurch weist der Dauermagnet eine u-förmige Ausbildung mit einer Magnetisierung in der Y-Richtung auf.

Der Halbleiterkörper 30 ist in etwa mittig zwischen den Schenkeln 128 angeordnet. Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, der Geber 40 beeinflusst die beiden Magnetfeldsensoren 34 und 38 symmetrisch.

In der Abbildung der Figur 1c ist eine Draufsicht auf die erste erfindungsgemäße Ausführungsform in einer Ansicht in der X-Y-Ebene dargestellt. Im Folgenden werden nur die Unterschiede zu der Figur 1a und der Fig. 1b erläutert. Aus Gründen der Anschaulichkeit ist der Geber 40 nicht dargestellt.

In Y-Richtung weist der Dauermagnet 20 anliegend an den Nordpol 28 den Südpol 24 auf. Der Südpol 24 ist in geometrische Hinsicht genau wie der Nordpol 28 ausgebildet, d.h. der Südpol 24 weist zwei Schenkel 124 und einen dazwischenliegenden Bodenbereich 130 auf. Die Schenkel 124 des Südpols 124 und die Schenkel 128 des Nordpols 28 sind entlang der Y-Achse ausgebildet.

Der erste Magnetfeldsensor 34 ist im Bereich zwischen den beiden Schenkel 124 des Südpols 24 und der zweite Magnetfeldsensor 28 zwischen den beiden Schenkel 128 des Nordpols 28 angeordnet. Der Halbleiterkörper 20 weist seine Längsachse entlang der Y-Achse auf und ist genau zentrisch oder nahezu zentrisch zwischen den Schenkeln 24, und 28 des Magneten 20 angeordnet. Die beiden Magnetfeldsensoren 34 und 38 sind entlang der Längsachse in der Y-Richtung voneinander beabstandet. Anders ausgedrückt durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die gedachte Abstandsgerade zwischen den beiden Magnetfeldsensoren 34 und 38 an der Oberfläche des Halbleiterkörpers 20.

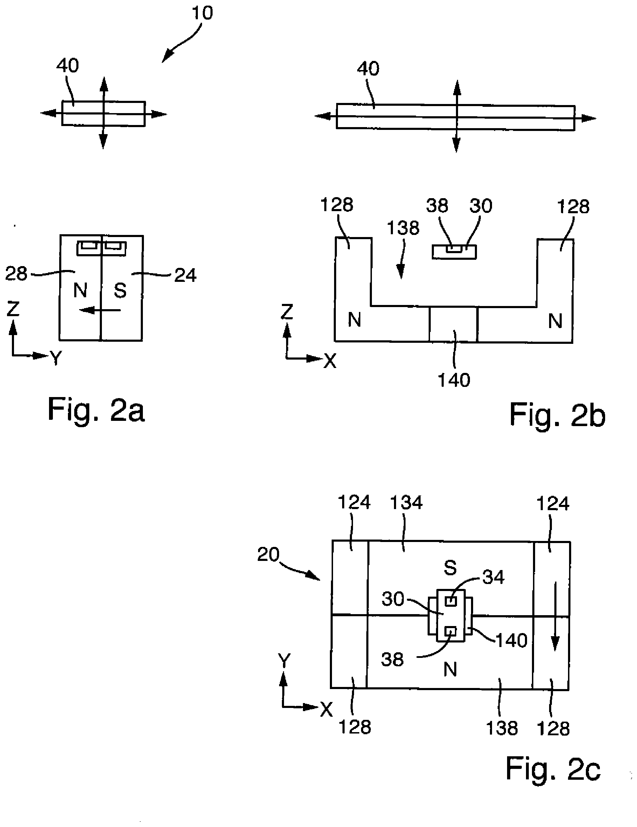

Die Abbildung der Figur 2a zeigt eine Draufsicht auf eine zweite erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegengesetzt zur Y-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist.

In der Abbildung der Figur 2b ist eine Draufsicht auf die zweite erfindungsgemäße Ausführungsform in einer Ansicht in der X-Z-Ebene dargestellt. Im Folgenden werden nur die Unterschiede zu der Figur 2a erläutert.

Der Dauermagnet 20 weist als Nordpol 28 zwei in der X-Richtung beabstandete Schenkel 128 auf. Zwischen den Schenkeln 128 des Nordpols 28 ist ein Bodenbereich 130 ebenfalls als Nordpol 28 ausgebildet. Hierdurch weist der Dauermagnet eine u-förmige Ausbildung mit einer Magnetisierung in der Y-Richtung auf. In der Mitte des Bodenbereichs 130 weist der Dauermagnet 20 ein Loch 140 auf.

Der Halbleiterkörper 30 ist in etwa mittig zwischen den Schenkeln 128 und in Z-Richtung gesehen oberhalb des Lochs 140 angeordnet. Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt beeinflusst die beiden Magnetfeldsensoren symmetrisch.

In der Abbildung der Figur 2c ist eine Draufsicht auf die zweite erfindungsgemäße Ausführungsform in einer Ansicht in der X-Y-Ebene dargestellt. Im Folgenden werden nur die Unterschiede zu der Figur 2a und der Fig. 2b erläutert. Aus Gründen der Anschaulichkeit ist der Geber 40 nicht dargestellt.

In Y-Richtung weist der Dauermagnet 20 anliegend an den Nordpol 28 den Südpol 24 auf. Der Südpol 24 ist in geometrische Hinsicht genau wie der Nordpol 28 ausgebildet, d.h. der Südpol 24 weist zwei Schenkel 124 und einen dazwischenliegenden Bodenbereich 134 auf. Die Schenkel 124 des Südpols 124 und die Schenkel 128 des Nordpols 28 sind entlang der Y-Achse ausgebildet. Das Loch 140 ist viereckig ausgebildet und enthält den Flächenmittelpunkt des Bodenbereichs 130. Die Hälfte der Fläche des Lochs 140 ist in dem Bodenbereich 130 des Nordpols 28 und die andere Hälfte der Fläche des Lochs 140 in dem Bodenbereich 130 des Südpols 24 angeordnet.

Der erste Magnetfeldsensor 34 ist in dem Bereich zwischen den beiden Schenkel 124 des Südpols 24 und der zweite Magnetfeldsensor 28 zwischen den beiden Schenkel 128 des Nordpols 28 angeordnet. Der Halbleiterkörper 20 ist genau zentrisch oder nahezu zentrisch zwischen den Schenkeln 24, und 28 des Magneten 20 und in Z-Richtung mittig vorzugsweise genau mittig über dem Loch 140 angeordnet.

Anders ausgedrückt durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die gedachte Abstandsgerade zwischen den beiden Magnetfeldsensoren 34 und 38 an der Oberfläche des Halbleiterkörpers 20.

Die Abbildung der Figur 3a zeigt eine Draufsicht auf eine dritte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung in X-Richtung und einem Nordpol 28 sowie einem von dem Nordpol 28 verdeckten Südpol 24 und einen Halbleiterkörper 30 mit einem ersten monolithisch integrierten Magnetfeldsensor 34 und einem zweiten von dem ersten Magnetfeldsensor 34 verdeckten monolithisch integrierten Magnetfeldsensor 38 und einen ferromagnetischen plattenförmigen symmetrischen Geber 40. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist.

In der Abbildung der Figur 3b ist eine Draufsicht auf die dritte erfindungsgemäße Ausführungsform in einer Ansicht in der X-Z-Ebene dargestellt. Im Folgenden werden nur die Unterschiede zu der Figur 3a erläutert.

Der Dauermagnet 20 weist zwei in der X-Richtung beabstandete und jeweils in der Y-Richtung ausgebildete Schenkel 124 und 128 auf. Zwischen dem Schenkel 124 des Südpols und dem Schenkel 128 des Nordpols 28 ist ein Bodenbereich 130 zur Hälfte als Südpol 24 und in der verbleibenden Hälfte als Nordpol 28 ausgebildet, anders ausgerückt wechselt die Polarität entlang der X-Achse in der Mitte des Bodenbereichs 130. Der Dauermagnet weist eine u-förmige Ausbildung mit einer Magnetisierung in der X-Richtung auf.

In einer nicht dargestellten Ausführungsform weist der Dauermagnet 20 in der Mitte des Bodenbereichs 130 ein Loch 140 auf.

Der Halbleiterkörper 30 ist in etwa mittig zwischen dem Schenkel 124 und dem Schenkel 128 und in Z-Richtung gesehen oberhalb des Bodenbereichs 130 angeordnet. Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, die beiden Magnetfeldsensoren werden mittels des Gebers 40 symmetrisch beeinflusst.

In der Abbildung der Figur 3c ist eine Draufsicht auf die dritte erfindungsgemäße Ausführungsform in einer Ansicht in der X-Y-Ebene dargestellt. Im Folgenden werden nur die Unterschiede zu der Figur 3a und der Fig. 3b erläutert. Aus Gründen der Anschaulichkeit ist der Geber 40 nicht dargestellt.

In X-Richtung weist der Dauermagnet 20 anliegend an den Nordpol 28 den Südpol 24 auf. Der Südpol 24 ist in geometrische Hinsicht genau wie der Nordpol 28 ausgebildet. Der Schenkel 124 des Südpols 24 und der Schenkel 128 des Nordpols 28 sind jeweils entlang der Y-Achse ausgebildet und liegen sich einander parallel gegenüber.

Der erste Magnetfeldsensor 34 ist oberhalb des Bodenbereichs 130 des Südpols 24 und der zweite Magnetfeldsensor 28 ist oberhalb des Bodenbereichs 130 des Nordpols 28 angeordnet. Der Halbleiterkörper 20 ist genau zentrisch oder nahezu zentrisch zwischen den Schenkeln 24 und 28 des Magneten 20 und in Z-Richtung angeordnet. Die beiden Magnetfeldsensoren 34 und 38 sind entlang der Längsachse des Halbleiterkörpers 20 in der X-Richtung voneinander beabstandet.

Anders ausgedrückt, durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die gedachte Abstandsgerade zwischen den beiden Magnetfeldsensoren 34 und 38 an der Oberfläche des Halbleiterkörpers 20.

In der nicht dargestellten Ausführungsform umfasst der Bodenbereich 130 das Loch 140. Das Loch 140 ist viereckig ausgebildet und enthält den Flächenmittelpunkt des Bodenbereichs 130. Die Hälfte der Fläche des Lochs 140 ist in dem Bodenbereich 130 des Nordpols 28 und die andere Hälfte der Fläche des Lochs 140 in dem Bodenbereich 130 des Südpols 24 angeordnet. Der Halbleiterkörper 20 ist genau zentrisch oder nahezu zentrisch zwischen den Schenkeln 24 und 28 des Magneten 20 und in Z-Richtung mittig vorzugsweise genau mittig über dem Loch 140 angeordnet.

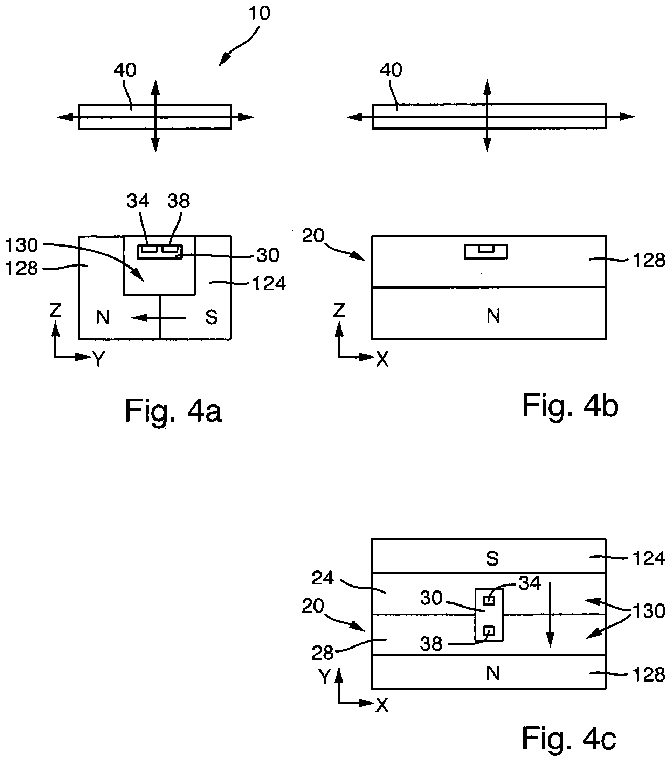

Die Abbildung der Figur 4a zeigt eine Draufsicht auf eine vierte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegengesetzt zur Y-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Die beiden Magnetfeldsensoren 34 und 38 sind in der Y-Richtung voneinander beabstandet. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist.

In Y-Richtung weist der Dauermagnet 20 anliegend an den Nordpol 28 den Südpol 24 auf. Der Südpol 24 ist in geometrische Hinsicht genau wie der Nordpol 28 ausgebildet. Die Schenkel 124 des Südpols 24 und die Schenkel 128 des Nordpols 28 sind jeweils entlang der X-Achse ausgebildet und liegen sich einander in paralleler Weise gegenüber.

Der erste Magnetfeldsensor 34 ist oberhalb des Bodenbereichs 130 des Südpols 24 und der zweite Magnetfeldsensor 28 ist oberhalb des Bodenbereichs 130 des Nordpols 28 angeordnet. Der Halbleiterkörper 20 ist genau zentrisch oder nahezu zentrisch zwischen den Schenkeln 24 und 28 des Magneten 20 und in Z-Richtung beabstandet von dem Bodenbereich 130 angeordnet. Die beiden Magnetfeldsensoren 34 und 38 sind entlang der Längsachse des Halbleiterkörpers 20 in der Y-Richtung voneinander beabstandet.

In der Abbildung der Figur 4b ist eine Draufsicht auf die vierte erfindungsgemäße Ausführungsform in einer Ansicht in der X-Z-Ebene dargestellt. Im Folgenden werden nur die Unterschiede zu der Figur 4a erläutert.

Der Halbleiterkörper 30 ist nicht sichtbar sondern verdeckt von dem Schenkel 128. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, der Geber 40 beeinflusst die beiden Magnetfeldsensoren 34 und 38 symmetrisch.

In einer nicht dargestellten Ausführungsform weist der Dauermagnet 20 in der Mitte des Bodenbereichs 130 ein Loch 140 auf.

In der Abbildung der Figur 4c ist eine Draufsicht auf die vierte erfindungsgemäße Ausführungsform in einer Ansicht in der X-Y-Ebene dargestellt. Im Folgenden werden nur die Unterschiede zu der Figur 4a und der Fig. 4b erläutert. Aus Gründen der Anschaulichkeit ist der Geber 40 nicht dargestellt.

In Y-Richtung weist der Dauermagnet 20 anliegend an den Nordpol 28 den Südpol 24 auf. Der Südpol 24 ist in geometrische Hinsicht genau wie der Nordpol 28 ausgebildet, d.h. der Südpol 24 weist einen Schenkel 124 und einen dazwischenliegenden Bodenbereich 130 auf. Der Schenkel 124 des Südpols 124 und der Schenkel 128 des Nordpols 28 sind entlang der X-Achse einander gegenüberliegend parallel ausgebildet.

Der erste Magnetfeldsensor 34 ist im Bereich zwischen dem Schenkel 124 des Südpols 24 und der zweite Magnetfeldsensor 28 zwischen den beiden Schenkel 128 des Nordpols 28 angeordnet. Der Halbleiterkörper 20 weist seine Längsachse entlang der Y-Achse auf und ist genau zentrisch oder nahezu zentrisch zwischen den Schenkeln 24 und 28 des Magneten 20 angeordnet. Die beiden Magnetfeldsensoren 34 und 38 sind entlang der Längsachse in der Y-Richtung voneinander beabstandet.

Anders ausgedrückt durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die gedachte Abstandsgerade zwischen den beiden Magnetfeldsensoren 34 und 38 an der Oberfläche des Halbleiterkörpers 20.

In der nicht dargestellten Ausführungsform umfasst der Bodenbereich 130 das Loch 140. Das Loch 140 ist viereckig ausgebildet und enthält den Flächenmittelpunkt des Bodenbereichs 130. Die Hälfte der Fläche des Lochs 140 ist in dem Bodenbereich 130 des Nordpols 28 und die andere Hälfte der Fläche des Lochs 140 in dem Bodenbereich 130 des Südpols 24 angeordnet.

Der Halbleiterkörper 20 ist genau zentrisch oder nahezu zentrisch zwischen den Schenkeln 24 und 28 des Magneten 20 und in Z-Richtung mittig vorzugsweise genau mittig über dem Loch 140 angeordnet.

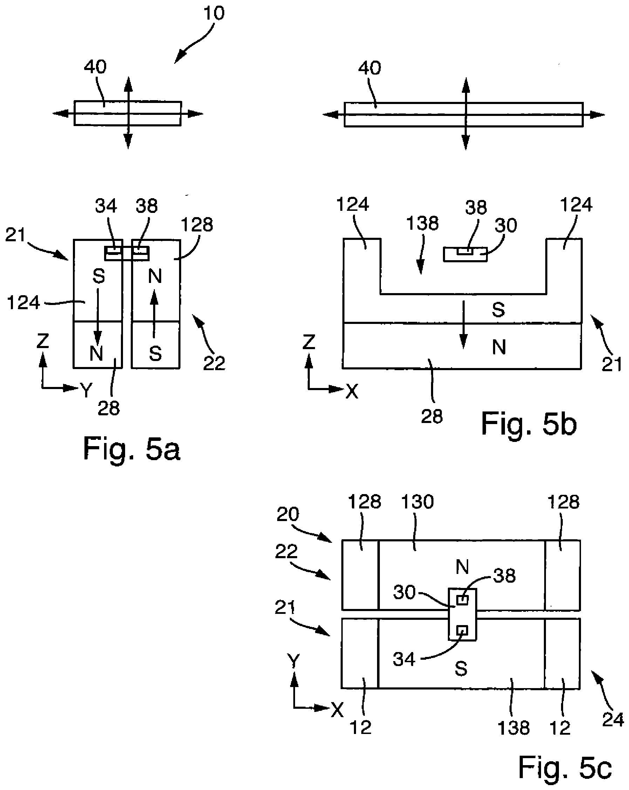

Die Abbildung der Figur 5a zeigt eine Draufsicht auf eine fünfte erfindungsgemäße Ausführungsform einer Abstandsmessvorrichtung 10 in einer Ansicht in der Y-Z-Ebene. Die Abstandsmessvorrichtung 10 umfasst einen aus einem ersten Teil 21 und einen zweiten Teil 22 ausgebildeten Dauermagneten 20 mit einer Magnetisierungsrichtung in bzw. entgegengesetzt zur Z-Richtung und sich jeweils daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Der erste Teil 21 des Dauermagneten 20 und der zweite Teil 22 des Dauermagneten 20 weisen jeweils eine vertikale d.h. in Richtung der Z-Achse ausgebildete Magnetisierung auf. Die beiden Magnetfeldsensoren 34 und 38 sind in der Y-Richtung voneinander beabstandet. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist.

Der erste Teil 21 und der zweite Teil 22 des Dauermagneten sind durch einen Spalt kleiner als 10 mm vorzugsweise kleiner als 3 mm voneinander beabstandet. In einer nicht dargestellten Ausführungsform sind die beiden Teile durch einen magnetischen Kraftschluss miteinander verbunden ohne Spalt verbunden.

In Y-Richtung liegt an den ersten Teil 21 des Dauermagneten 20 an der Unterseite an dem Nordpol 28 der Südpol 24 des zweiten Teils 22 des Dauermagneten 20 an. An der Oberseite liegt an dem Südpol des ersten Teils 21 des Dauermagneten 20 der Nordpol 28 des zweiten Teils 22 des Dauermagneten 20 an. Anders ausgedrückt, der erste Teil 21 des Dauermagneten 20 weist zu dem zweiten Teil 22 des Dauermagneten 20 eine entgegengesetzte Magnetisierungsrichtung auf.

Der erste Magnetfeldsensor 34 ist oberhalb des Bodenbereichs 130 des Südpols 24 und der zweite Magnetfeldsensor 28 ist oberhalb des Bodenbereichs 130 des Nordpols 28 angeordnet. Der Halbleiterkörper 20 ist genau zentrisch oder nahezu zentrisch zwischen den Schenkeln 24 und 28 des Magneten 20 und in Z-Richtung beabstandet von dem Bodenbereich 130 angeordnet. Die beiden Magnetfeldsensoren 34 und 38 sind entlang der in der Y-Richtung ausgebildeten Längsachse des Halbleiterkörpers 20 voneinander beabstandet.

In der Abbildung der Figur 5b ist eine Draufsicht auf die fünfte erfindungsgemäße Ausführungsform in einer Ansicht in der X-Z-Ebene dargestellt. Im Folgenden werden nur die Unterschiede zu der Figur 5a erläutert.

Der Halbleiterkörper 30 ist entlang der Y-Richtung ausgebildet und nur an der Kopfseite sichtbar. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, der Geber 40 beeinflusst die beiden Magnetfeldsensoren 34 und 38 symmetrisch.

In einer nicht dargestellten Ausführungsform weist der Dauermagnet 20 in der Mitte des Bodenbereichs 130 ein Loch 140 auf.

In der Abbildung der Figur 5c ist eine Draufsicht auf die fünfte erfindungsgemäße Ausführungsform in einer Ansicht in der X-Y-Ebene dargestellt. Im Folgenden werden nur die Unterschiede zu der Figur 5a und der Fig. 5b erläutert. Aus Gründen der Anschaulichkeit ist der Geber 40 nicht dargestellt.

Der Südpol 24 des ersten Teils 21 ist in geometrischer Hinsicht genau wie der Nordpol 28 des zweiten Teils 22 ausgebildet. Die beiden sich einander gegenüberliegenden beiden Schenkel 124 des Südpols 24 des ersten Teils 21 und die beiden sich einander gegenüberliegenden beiden Schenkel 128 des Nordpols 28 des zweiten Teils 22 sind jeweils entlang der X-Richtung ausgebildet. Die jeweils einander gegenüberliegenden Schenkel 124 und die jeweils einander gegenüberliegenden Schenkel 128 sind in X-Richtung parallel verlaufend ausgebildet.

In Y-Richtung weist der Dauermagnet 20 anliegend an den Südpol 24 des ersten Teils 21 der Nordpol 28 des zweiten Teils 22 auf. Der Südpol 24 des ersten Teils 21 ist in geometrische Hinsicht genau wie der Nordpol 28 des zweiten Teils 22 ausgebildet, d.h. der Südpol 24 des ersten Teils 21 weist zwei einander gegenüberliegende Schenkel 124 und einen dazwischen liegenden Bodenbereich 130 genauso wie der Nordpol 28 des zweiten Teils 22 zwei sich einander gegenüberliegenden Schenkel 128 und einen dazwischenlegenden Bodenbereich 130 aufweist.

Der erste Magnetfeldsensor 34 ist im Bereich zwischen dem Schenkel 124 des Südpols 24 und der zweite Magnetfeldsensor 28 zwischen den beiden Schenkel 128 des Nordpols 28 angeordnet. Der Halbleiterkörper 20 weist seine Längsachse entlang der Y-Achse auf und ist genau zentrisch oder nahezu zentrisch zwischen den Schenkeln 24 und 28 des Magneten 20 angeordnet. Die beiden Magnetfeldsensoren 34 und 38 sind entlang der Längsachse in der Y-Richtung voneinander beabstandet. Entlang parallel zur Y-Achse ausgebildeten Mittellinie in der Mitte des Bodenbereichs 130, verläuft der Polaritätswechsel zwischen dem Südpol 24 und dem Nordpol 28.

Anders ausgedrückt, die in der Z-Richtung ausgebildete Normale durchdringt an der Stelle des Schwerpunkts des Dauermagneten 20, ausgehend von der Mitte des Bodenbereichs 130, den Flächenschwerpunkt an der Oberfläche des Halbleiterkörpers 30 und halbiert hierdurch auch die gedachte Abstandsgerade zwischen den beiden Magnetfeldsensoren 34 und 38 an der Oberfläche des Halbleiterkörpers 20.

In der nicht dargestellten Ausführungsform umfasst der Bodenbereich 130 das Loch 140. Das Loch 140 ist viereckig ausgebildet und enthält den Flächenmittelpunkt des Bodenbereichs 130. Die Hälfte der Fläche des Lochs 140 ist in dem Bodenbereich 130 des Nordpols 28 und die andere Hälfte der Fläche des Lochs 140 in dem Bodenbereich 130 des Südpols 24 angeordnet.

Der Halbleiterkörper 20 ist genau zentrisch oder nahezu zentrisch zwischen den Schenkeln 24 und 28 des Magneten 20 und in Z-Richtung mittig vorzugsweise genau mittig über dem Loch 140 angeordnet.

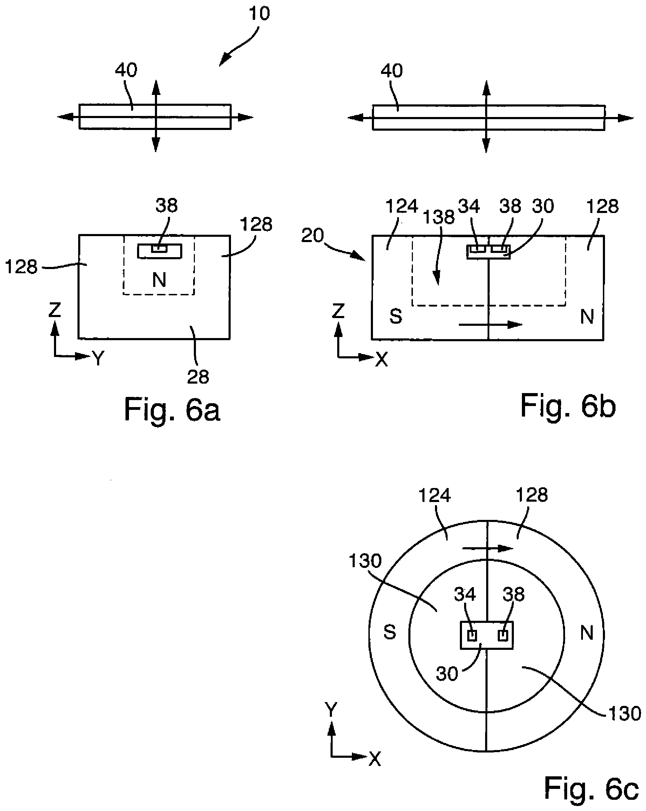

Die Abbildung der Figur 6a zeigt eine Draufsicht auf eine sechste erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung in zur X-Richtung und sich daraus ergebenden Nordpol 28 und einem von dem Nordpol 28 verdeckten Südpol 24 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist. Vorliegend ist der erste Magnetfeldsensor 34 von dem zweiten Magnetfeldsensor 38 verdeckt.

In der Abbildung der Figur 6b ist eine Draufsicht auf die sechste erfindungsgemäße Ausführungsform in einer Ansicht in der X-Z-Ebene dargestellt. Im Folgenden werden nur die Unterschiede zu der Figur 6a erläutert.

Der kreisförmige und topfförmige ausgebildete Dauermagnet 20 weist einen halbkreisförmigen Schenkel 124 des Südpols 24 und einen gegenüberliegenden halbkreisförmigen Schenkel 128 des Nordpols 28 auf. Zwischen dem Schenkel 124 des Südpols 24 und dem Schenkel 128 des Nordpols 28 ist ein Bodenbereich 130 zur Hälfte als Südpol 24 und in der verbleibenden Hälfte als Nordpol 28 ausgebildet, anders ausgedrückt, die Polarität wechselt entlang der X-Achse in der Mitte des Bodenbereichs 130. Die Fläche an der die Polarität von Süd nach Nord wechselt ist in der Y-Z Ebene ausgebildet. Der Dauermagnet weist eine Magnetisierung in der X-Richtung auf.

Der Halbleiterkörper 30 weist eine Längsachse in X-Richtung auf und ist in etwa mittig zwischen dem Schenkel 124 und dem Schenkel 128 und in Z-Richtung gesehen oberhalb des Bodenbereichs 130 angeordnet. Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, die beiden Magnetfeldsensoren werden mittels des Gebers 40 symmetrisch beeinflusst.

In der Abbildung der Figur 6c ist eine Draufsicht auf die dritte erfindungsgemäße Ausführungsform in einer Ansicht in der X-Y-Ebene dargestellt. Im Folgenden werden nur die Unterschiede zu der Figur 6a und der Fig. 6b erläutert. Aus Gründen der Anschaulichkeit ist der Geber 40 nicht dargestellt.

In X-Richtung weist der Dauermagnet 20 anliegend an den Südpol 24 den Nordpol 28 auf. Der Südpol 24 ist in geometrische Hinsicht genau wie der Nordpol 28 ausgebildet. Der halbkreisförmige Schenkel 124 des Südpols 24 und der der halbkreisförmige Schenkel 128 des Nordpols 28 liegen sich einander größtenteils gegenüber und berühren sich an der Fläche Y-Z an der der Polaritätswechsel stattfindet.

Der erste Magnetfeldsensor 34 ist oberhalb des Bodenbereichs 130 des Südpols 24 und der zweite Magnetfeldsensor 28 ist oberhalb des Bodenbereichs 130 des Nordpols 28 angeordnet. Der Halbleiterkörper 20 ist genau zentrisch oder nahezu zentrisch zwischen den beiden halbkreisförmigen Schenkeln 24 und 28 des Magneten 20 und in Z-Richtung von dem Bodenbereichs 130 beabstandet, angeordnet. Die beiden Magnetfeldsensoren 34 und 38 sind entlang der Längsachse des Halbleiterkörpers 20 in der X-Richtung voneinander beabstandet.

Anders ausgedrückt, durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die gedachte Abstandsgerade zwischen den beiden Magnetfeldsensoren 34 und 38 an der Oberfläche des Halbleiterkörpers 20.

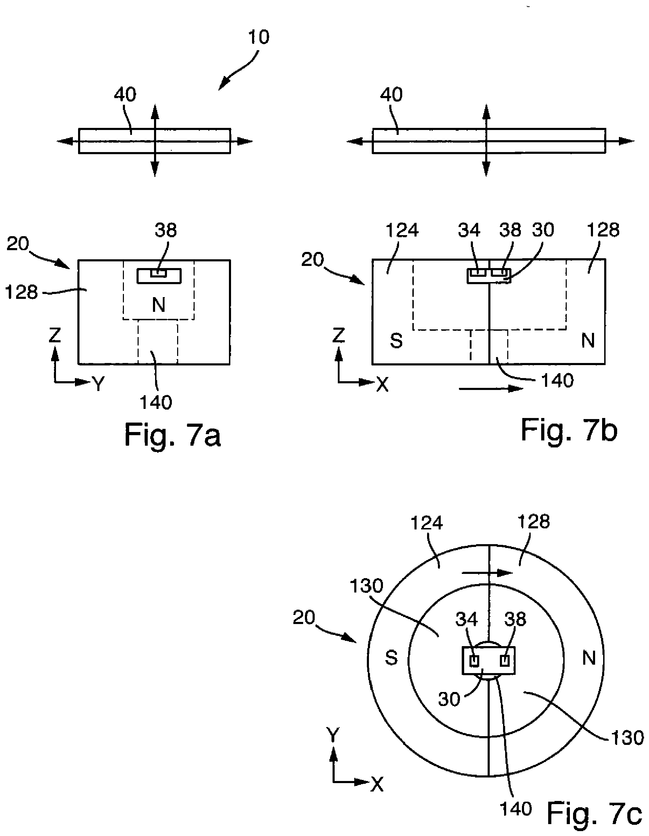

Die Abbildung der Figur 7a zeigt eine Draufsicht auf eine siebente erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung in X-Richtung und sich daraus ergebendem Nordpol 28 und einem von dem Nordpol 28 verdeckten Südpol 24 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist. Vorliegend ist der erste Magnetfeldsensor 34 von dem zweiten Magnetfeldsensor 38 verdeckt.

In der Abbildung der Figur 7b ist eine Draufsicht auf die siebente erfindungsgemäße Ausführungsform in einer Ansicht in der X-Z-Ebene dargestellt. Im Folgenden werden nur die Unterschiede zu der Figur 7a erläutert.

Der kreisförmige und topfförmige ausgebildete Dauermagnet 20 weist einen halbkreisförmigen Schenkel 124 des Südpols 24 und einen gegenüberliegenden halbkreisförmigen Schenkel 128 des Nordpols 28 auf. Zwischen dem Schenkel 124 des Südpols 24 und dem Schenkel 128 des Nordpols 28 ist ein Bodenbereich 130 zur Hälfte als Südpol 24 und in der verbleibenden Hälfte als Nordpol 28 ausgebildet, anders ausgedrückt, die Polarität wechselt entlang der X-Achse in der Mitte des Bodenbereichs 130. Die Fläche an der die Polarität von Süd nach Nord wechselt ist in der Y-Z Ebene ausgebildet. Der Dauermagnet weist eine Magnetisierung in der X-Richtung auf.

Der Halbleiterkörper 30 weist eine Längsachse in X-Richtung auf und ist in etwa mittig zwischen dem Schenkel 124 und dem Schenkel 128 und in Z-Richtung gesehen oberhalb des Bodenbereichs 130, jedoch innerhalb der der in Z-Richtung ausgebildeten Höhe der Schenkel 124 und 128 angeordnet. Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, die beiden Magnetfeldsensoren werden mittels des Gebers 40 symmetrisch beeinflusst.

In der Mitte des Bodenbereichs 130 weist der Dauermagnet ein Loch 140 auf.

In der Abbildung der Figur 7c ist eine Draufsicht auf die siebente erfindungsgemäße Ausführungsform In einer Ansicht in der X-Y-Ebene dargestellt. Im Folgenden werden nur die Unterschiede zu der Figur 7a und der Fig. 7b erläutert. Aus Gründen der Anschaulichkeit ist der Geber 40 nicht dargestellt.

In X-Richtung weist der Dauermagnet 20 anliegend an den Südpol 24 den Nordpol 28 auf. Der Südpol 24 ist in geometrische Hinsicht genau wie der Nordpol 28 ausgebildet. Der halbkreisförmige Schenkel 124 des Südpols 24 und der halbkreisförmige Schenkel 128 des Nordpols 28 liegen sich einander größtenteils gegenüber und berühren sich an der Fläche Y-Z an der der Polaritätswechsel stattfindet.

Der erste Magnetfeldsensor 34 ist oberhalb des Bodenbereichs 130 des Südpols 24 und der zweite Magnetfeldsensor 28 ist oberhalb des Bodenbereichs 130 des Nordpols 28 angeordnet. Der Halbleiterkörper 20 ist genau zentrisch oder nahezu zentrisch zwischen den beiden halbkreisförmigen Schenkeln 24 und 28 des Magneten 20 und in Z-Richtung von dem Bodenbereichs 130 beabstandet, angeordnet. Die beiden Magnetfeldsensoren 34 und 38 sind entlang der Längsachse des Halbleiterkörpers 20 in der X-Richtung voneinander beabstandet.

Das in den zentralen Bodenbereich 130 angeordnete Loch 140 ist rund ausgebildet und enthält den Flächenmittelpunkt des Bodenbereichs 130. Die Hälfte der Fläche des Lochs 140 ist in dem Bodenbereich 130 des Nordpols 28 und die andere Hälfte der Fläche des Lochs 140 in dem Bodenbereich 130 des Südpols 24 angeordnet.

Der erste Magnetfeldsensor 34 ist in dem Bereich umgeben von dem halbkreisförmigen Schenkel 124 des Südpols 24 und der zweite Magnetfeldsensor 38 ist in dem Bereich umgeben von dem halbkreisförmigen Schenkel 128 des Nordpols 28 angeordnet. Der Halbleiterkörper 30 ist hierdurch in der Mitte von dem halbkreisförmigen Schenkel 124 des Südpols 24 und halbkreisförmigen Schenkel 128 des Nordpols 28 und in Z-Richtung mittig vorzugsweise genau mittig über dem Loch 140 angeordnet.

Anders ausgedrückt, durchdringt die in der Z-Richtung ausgebildete Normale an der Stelle des Schwerpunkts des Dauermagneten 20 ausgehend von der Mitte des Bodenbereichs 130, d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

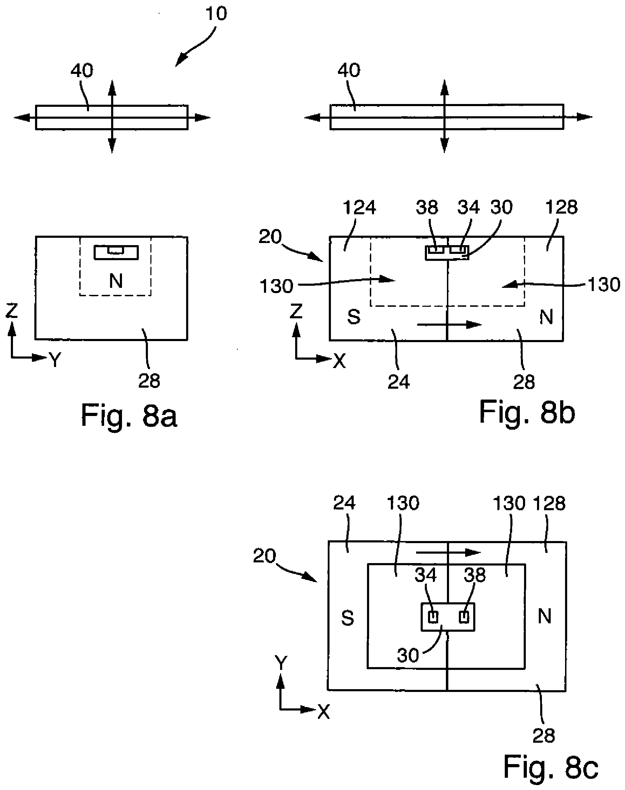

Die Abbildung der Figur 8a zeigt eine Draufsicht auf eine achte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung in X-Richtung und sich daraus ergebenden Nordpol 28 und einem von dem Nordpol 28 verdeckten Südpol 24 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist. Vorliegend ist der erste Magnetfeldsensor 34 von dem zweiten Magnetfeldsensor 38 verdeckt.

In der Abbildung der Figur 8b ist eine Draufsicht auf die achte erfindungsgemäße Ausführungsform in einer Ansicht in der X-Z-Ebene dargestellt. Im Folgenden werden nur die Unterschiede zu der Figur 8a erläutert.

Der viereckige und topfartige ausgebildete Dauermagnet 20 weist einen in der X-Richtung ausgebildeten u-förmigen Schenkel 124 des Südpols 24 und einen gegenüberliegenden ebenfalls in der X-Richtung ausgebildeten u-förmigen Schenkel 128 des Nordpols 28 auf. Zwischen dem Schenkel 124 des Südpols 24 und dem Schenkel 128 des Nordpols 28 ist ein Bodenbereich 130 zur Hälfte als Südpol 24 und in der verbleibenden Hälfte als Nordpol 28 ausgebildet, anders ausgedrückt, die Polarität wechselt entlang der X-Achse in der Mitte des Bodenbereichs 130. Die Fläche an der die Polarität von Süd nach Nord wechselt ist in der Y-Z Ebene ausgebildet. Der Dauermagnet weist eine Magnetisierung in der X-Richtung auf.

Der Halbleiterkörper 30 weist eine Längsachse in X-Richtung auf und ist in etwa mittig zwischen dem Schenkel 124 und dem Schenkel 128 und in Z-Richtung gesehen oberhalb des Bodenbereichs 130, jedoch innerhalb der der in Z-Richtung ausgebildeten Höhe der Schenkel 124 und 128 angeordnet. Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, die beiden Magnetfeldsensoren werden mittels des Gebers 40 symmetrisch beeinflusst.

In einer nicht dargestellten Ausführungsform ist in der Mitte des Bodenbereichs 130 ein viereckiges Loch 140 ausgebildet.

In der Abbildung der Figur 8c ist eine Draufsicht auf die achte erfindungsgemäße Ausführungsform in einer Ansicht in der X-Y-Ebene dargestellt. Im Folgenden werden nur die Unterschiede zu der Figur 8a und der Fig. 8b erläutert. Aus Gründen der Anschaulichkeit ist der Geber 40 nicht dargestellt.

In X-Richtung weist der Dauermagnet 20 anliegend an den Südpol 24 den Nordpol 28 auf. Der Südpol 24 ist in geometrische Hinsicht genau wie der Nordpol 28 ausgebildet. Der u-förmige Schenkel 124 des Südpols 24 und der u-förmige Schenkel 128 des Nordpols 28 liegen sich einander größtenteils gegenüber und berühren sich an der Fläche Y-Z an der der Polaritätswechsel stattfindet.

Der erste Magnetfeldsensor 34 ist oberhalb des Bodenbereichs 130 des Südpols 24 und der zweite Magnetfeldsensor 28 ist oberhalb des Bodenbereichs 130 des Nordpols 28 angeordnet. Der Halbleiterkörper 20 ist genau zentrisch oder nahezu zentrisch zwischen den beiden u-förmigen Schenkeln 24 und 28 des Magneten 20 und in Z-Richtung von dem Bodenbereichs 130 beabstandet, angeordnet. Die beiden Magnetfeldsensoren 34 und 38 sind entlang der Längsachse des Halbleiterkörpers 20 in der X-Richtung voneinander beabstandet.

In dem zentralen Bodenbereich 130 befindet sich auch der Schwerpunkt des Dauermagneten 20.

Der erste Magnetfeldsensor 34 ist in dem Bereich umgeben von dem u-förmigen Schenkel 124 des Südpols 24 und der zweite Magnetfeldsensor 38 ist in dem Bereich umgeben von dem u-förmigen Schenkel 128 des Nordpols 28 angeordnet. Der Halbleiterkörper 30 ist hierdurch in der Mitte von dem u-förmigen Schenkel 124 des Südpols 24 und u-förmigen Schenkel 128 des Nordpols 28 und in Z-Richtung mittig vorzugsweise genau mittig über dem Schwerpunkt angeordnet.

Anders ausgedrückt, durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

In einer nicht dargestellten Ausführungsform ist in dem zentralen Bodenbereich 130 das Loch 140 viereckig ausgebildet und enthält den Flächenmittelpunkt des Bodenbereichs 130. Die Hälfte der Fläche des Lochs 140 ist in dem Bodenbereich 130 des Nordpols 28 und die andere Hälfte der Fläche des Lochs 140 in dem Bodenbereich 130 des Südpols 24 angeordnet.

Anders ausgedrückt, durchdringt in der nicht dargestellten Ausführungsform die in der Z-Richtung ausgebildete Normale an der Stelle des Schwerpunkts des Dauermagneten 20 ausgehend von der Mitte des Bodenbereichs 130, d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

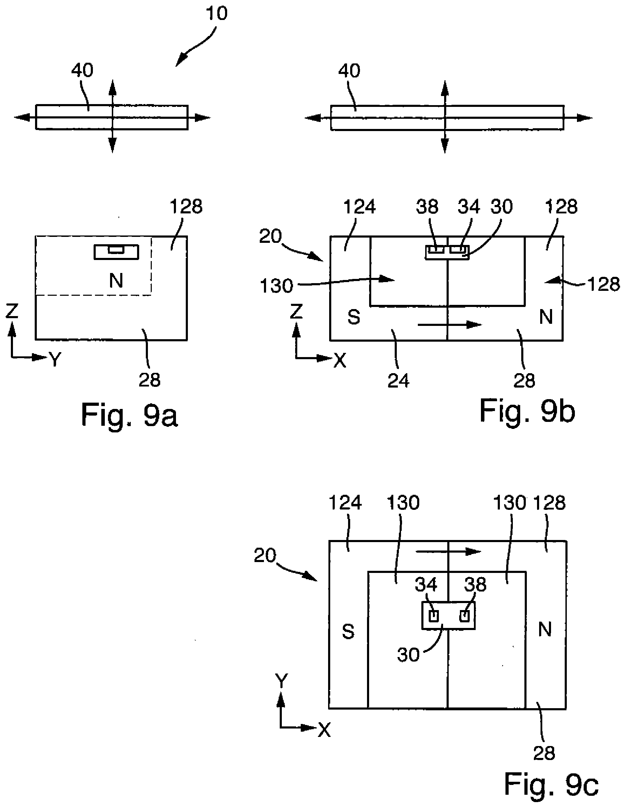

Die Abbildung der Figur 9a zeigt eine Draufsicht auf eine neunte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung in X-Richtung und sich daraus ergebenden Nordpol 28 und einem von dem Nordpol 28 verdeckten Südpol 24 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen symmetrischen Geber 40. Der Geber 40 ist in allen Raumrichtungen verschiebbar und weist In der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist. Vorliegend Ist der erste Magnetfeldsensor 34 von dem zweiten Magnetfeldsensor 38 verdeckt.

In der Abbildung der Figur 9b ist eine Draufsicht auf die neunte erfindungsgemäße Ausführungsform in einer Ansicht In der X-Z-Ebene dargestellt. Im Folgenden werden nur die Unterschiede zu der Figur 9a erläutert.

Der viereckige und teilweise topfartige ausgebildete Dauermagnet 20 weist einen in der X-Y-Richtung ausgebildeten winkelförmigen Schenkel 124 des Südpols 24 und einen gegenüberliegenden ebenfalls in der X-Y-Richtung ausgebildeten winkelförmigen Schenkel 128 des Nordpols 28 auf. Zwischen dem Schenkel 124 des Südpols 24 und dem Schenkel 128 des Nordpols 28 ist ein Bodenbereich 130 zur Hälfte als Südpol 24 und in der verbleibenden Hälfte als Nordpol 28 ausgebildet, anders ausgedrückt, die Polarität wechselt entlang der X-Achse in der Mitte des Bodenbereichs 130. Die Fläche an der die Polarität von Süd nach Nord wechselt ist in der Y-Z Ebene ausgebildet. Der Dauermagnet weist eine Magnetisierung in der X-Richtung auf. Dei teilweise topfartige Dauermagnet 20 ist Richtung der Y-Achse gesehen offen, d.h. entlang einer X-Z Ebene fehlt der umlaufende Wall in Bezug auch den Bodenbereich 130.

Der Halbleiterkörper 30 weist eine Längsachse in X-Richtung auf und ist in etwa mittig zwischen dem Schenkel 124 und dem Schenkel 128 und in Z-Richtung gesehen oberhalb des Bodenbereichs 130, jedoch innerhalb der der in Z-Richtung ausgebildeten Höhe der Schenkel 124 und 128 angeordnet. Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 gleichmäßig und anders ausgedrückt, die beiden Magnetfeldsensoren werden mittels des Gebers 40 symmetrisch beeinflusst.

In einer nicht dargestellten Ausführungsform ist in der Mitte des Bodenbereichs 130 ein viereckiges Loch 140 ausgebildet.

In der Abbildung der Figur 9c ist eine Draufsicht auf die neunte erfindungsgemäße Ausführungsform in einer Ansicht in der X-Y-Ebene dargestellt. Im Folgenden werden nur die Unterschiede zu der Figur 9a und der Fig. 9b erläutert. Aus Gründen der Anschaulichkeit ist der Geber 40 nicht dargestellt.

In X-Richtung weist der Dauermagnet 20 anliegend an den Südpol 24 den Nordpol 28 auf. Der Südpol 24 ist in geometrische Hinsicht genau wie der Nordpol 28 ausgebildet. Der winkelförmige Schenkel 124 des Südpols 24 und der winkelförmige Schenkel 128 des Nordpols 28 liegen sich einander größtenteils gegenüber und berühren sich nur an einer einzigen Fläche Y-Z an der der Polaritätswechsel stattfindet.

Der erste Magnetfeldsensor 34 ist oberhalb des Bodenbereichs 130 des Südpols 24 und der zweite Magnetfeldsensor 28 ist oberhalb des Bodenbereichs 130 des Nordpols 28 angeordnet. Der Halbleiterkörper 20 ist nahezu zentrisch zwischen den beiden winkelförmigen Schenkeln 24 und 28 des Magneten 20 und in Z-Richtung von dem Bodenbereichs 130 beabstandet, angeordnet. Die beiden Magnetfeldsensoren 34 und 38 sind entlang der Längsachse des Halbleiterkörpers 20 in der X-Richtung voneinander beabstandet.

In dem zentralen Bodenbereich 130 befindet sich auch der Schwerpunkt des Dauermagneten 20.

Der erste Magnetfeldsensor 34 ist in dem Bereich umgeben von dem winkelförmigen Schenkel 124 des Südpols 24 und der zweite Magnetfeldsensor 38 ist in dem Bereich umgeben von dem winkelförmigen Schenkel 128 des Nordpols 28 angeordnet. Der Halbleiterkörper 30 ist hierdurch in etwa in der Mitte von dem winkelförmigen Schenkel 124 des Südpols 24 und dem winkelförmige Schenkel 128 des Nordpols 28 und in Z-Richtung mittig vorzugsweise genau mittig über dem Schwerpunkt angeordnet.

Anders ausgedrückt, durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

In einer nicht dargestellten Ausführungsform ist in dem zentralen Bodenbereich 130 das Loch 140 viereckig ausgebildet und enthält den Flächenmittelpunkt des Bodenbereichs 130. Die Hälfte der Fläche des Lochs 140 ist in dem Bodenbereich 130 des Nordpols 28 und die andere Hälfte der Fläche des Lochs 140 in dem Bodenbereich 130 des Südpols 24 angeordnet.

Anders ausgedrückt, durchdringt in der nicht dargestellten Ausführungsform die in der Z-Richtung ausgebildete Normale an der Stelle des Schwerpunkts des Dauermagneten 20 ausgehend von der Mitte des Bodenbereichs 130, d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

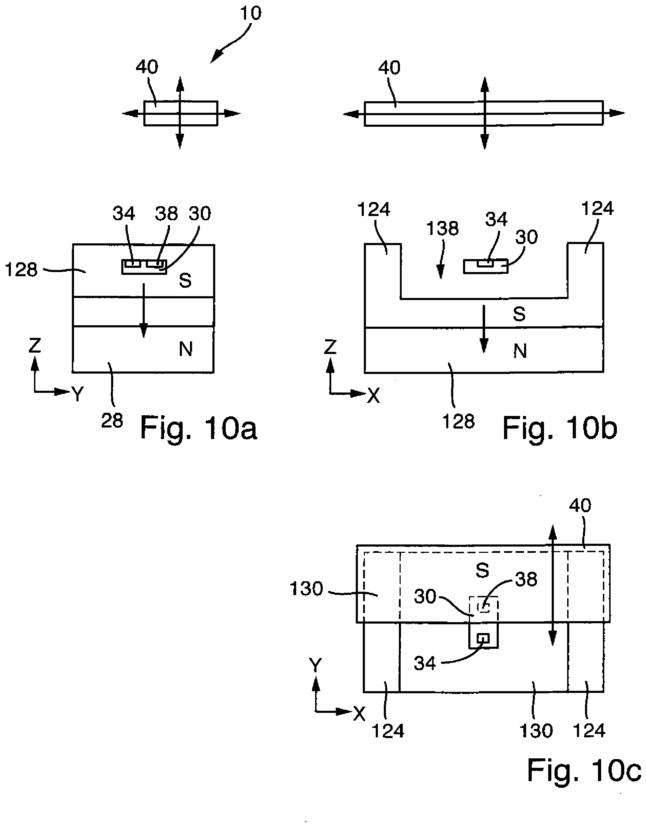

Die Abbildung der Figur 10a zeigt eine Draufsicht auf eine zehnte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebenden Südpol 24 und mit einem Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen Geber 40.

Der Geber 40 ist in allen Raumrichtungen verschiebbar und weist in der Y-Richtung vorzugsweise nur eine etwa halb so große oder kleinere Ausdehnung wie der Dauermagnet 20 auf. Der Halbleiterkörper 30 weist eine integrierte Auswerteschaltung auf, welche vorliegend nicht dargestellt ist. Vorliegend ist der erste Magnetfeldsensor 34 in der Y-Richtung beabstandet von dem zweiten Magnetfeldsensor 38 angeordnet.

Der Dauermagnet 20 weist eine in Z-Richtung ausgebildete vertikale Magnetisierung auf, wobei der Südpol 24 oberhalb des Nordpols 28 angeordnet ist.

In der Abbildung der Figur 10b ist eine Draufsicht auf die zehnte erfindungsgemäße Ausführungsform in einer Ansicht in der X-Z-Ebene dargestellt. Im Folgenden werden nur die Unterschiede zu der Figur 10a erläutert.

Der viereckige und nur teilweise in einer topfartigen Ausführung ausgebildete Dauermagnet 20 weist einen in der X-Y-Richtung ausgebildeten u-förmigen Schenkel 124 des Südpols 24 auf, wobei die Schenkel 124 entlang der Y-Richtung zueinander parallel ausgebildet sind, d.h. die beiden Schenkel 124 sind in X-Richtung beabstandet. Zwischen den Seiten des u-förmigen Schenkel 124 des Südpols 24 ist ein Bodenbereich 130 als Südpol 24 ausgebildet, anders ausgedrückt, die Polarität wechselt nur entlang der Z-Richtung. Die Magnetisierung ist also vertikal in der Z-Richtung. Der teilweise topfartig ausgeführte Dauermagnet 20 ist Richtung der Y-Achse gesehen offen, d.h. entlang einer X-Z Ebene fehlt der umlaufende als Südpol 24 ausgebildete Wall.

Der Halbleiterkörper 30 weist eine Längsachse in Y-Richtung auf und ist in etwa mittig zwischen dem aus dem u-förmigen Schenkel 124 gebildeten Bereich und in Z-Richtung gesehen oberhalb des Bodenbereichs 130, jedoch innerhalb der der in Z-Richtung ausgebildeten Höhe des Schenkels 124 angeordnet. Der Halbleiterkörper 30 ist in Z-Richtung von dem Bodenbereich 130 beabstandet. Der Geber 40 weist in der X-Richtung vorzugsweise eine vergleichbare oder größere Ausdehnung wie der Dauermagnet 20 auf. Der Geber 40 überdeckt hierdurch die beiden Magnetfeldsensoren 24 und 28 ungleichmäßig oder anders ausgedrückt, die beiden Magnetfeldsensoren werden mittels des Gebers 40 unsymmetrisch beeinflusst.

In einer nicht dargestellten Ausführungsform ist in der Mitte des Bodenbereichs 130 ein viereckiges Loch 140 ausgebildet.

In der Abbildung der Figur 10c ist eine Draufsicht auf die zehnte erfindungsgemäße Ausführungsform in einer Ansicht in der X-Y-Ebene dargestellt. Im Folgenden werden nur die Unterschiede zu der Figur 10a und der Fig. 10b erläutert. Der Gerber 40 bedeckt den Dauermagneten 20 nur teilweise.

Der u-förmige Schenkel 124 des Südpols 24 umschließt den Bodenbereich 130 nur an drei Seiten.

Beide Magnetfeldsensoren 34 und 38 sind entlang der Längsachse des Halbleiterkörpers 20 in der Y-Richtung voneinander beabstandet und sind oberhalb des Bodenbereichs 130 des Südpols 24 angeordnet. Der Halbleiterkörper 20 ist nahezu zentrisch zwischen dem u-förmigen Schenkel 24 und in Z-Richtung von dem Bodenbereichs 130 beabstandet, angeordnet.

In dem zentralen Bodenbereich 130 befindet sich auch der Schwerpunkt des Dauermagneten 20.

Beide Magnetfeldsensor 34 und 38 sind in dem Bereich des u-förmigen Schenkel 124 des Südpols 24 angeordnet. Der Halbleiterkörper 30 ist in etwa in der Mitte von dem u-förmigen Schenkel 124 des Südpols 24 und in Z-Richtung mittig vorzugsweise genau mittig über dem Schwerpunkt angeordnet.

Anders ausgedrückt, durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die in der Y-Richtung ausgebildete gedachte Abstandsgerade zwischen den beiden Magnetfeldsensoren 34 und 38 an der Oberfläche des Halbleiterkörpers 20.

In einer nicht dargestellten Ausführungsform ist in dem zentralen Bodenbereich 130 das Loch 140 viereckig ausgebildet und enthält den Flächenmittelpunkt des Bodenbereichs 130.

Anders ausgedrückt, durchdringt in der nicht dargestellten Ausführungsform die in der Z-Richtung ausgebildete Normale an der Stelle des Schwerpunkts des Dauermagneten 20 ausgehend von der Mitte des Bodenbereichs 130, d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

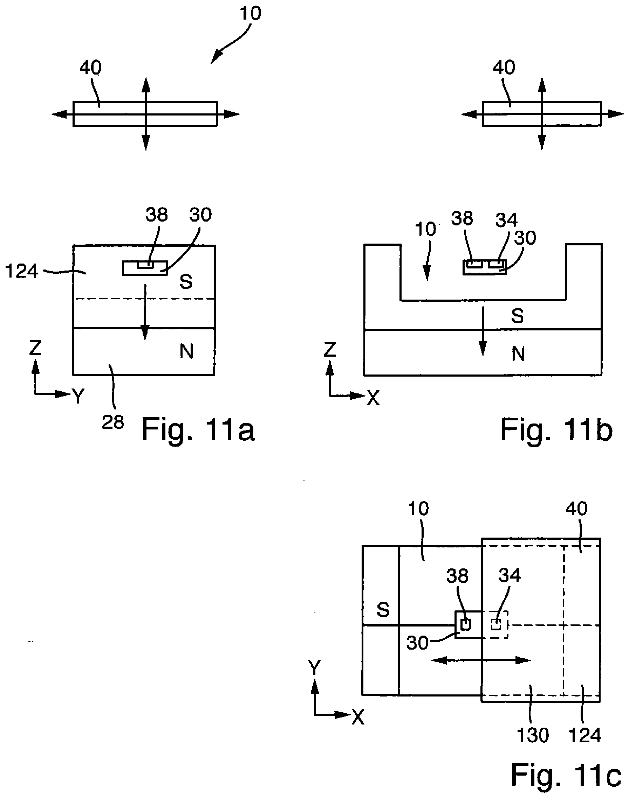

Die Abbildung der Figur 11a zeigt eine Draufsicht auf eine elfte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen Geber 40.

Die beiden Magnetfeldsensoren 34 und 38 sind in der x-Richtung voneinander beabstandet. Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist.

In Z-Richtung ist der Südpol 24 oberhalb des Nordpols 28 angeordnet, d.h. der Dauermagnet 20 weist eine vertikale Magnetisierung auf.

In der Abbildung der Figur 11b ist eine Draufsicht auf die elfte erfindungsgemäße Ausführungsform in einer Ansicht in der X-Z-Ebene dargestellt. Im Folgenden werden nur die Unterschiede zu der Figur 11a erläutert.

Der Dauermagnat 20 weist als Südpol 24 zwei in der X-Richtung beabstandete Schenkel 124 auf. Zwischen den Schenkeln 124 ist ein Bodenbereich 130 ebenfalls als Südpol 124 ausgebildet. Hierdurch weist der Dauermagnet eine u-förmige Ausbildung mit einer Magnetisierung in der Z-Richtung auf.

Der Halbleiterkörper 30 ist in etwa mittig zwischen den Schenkeln 124 angeordnet. Der Halbleiterkörper 30 ist in Z-Richtung von dem Bodenbereich 130 beabstandet. Der Geber 40 weist in der X-Richtung vorzugsweise nur eine etwa halb so große oder kleinere Ausdehnung wie der Dauermagnet 20 auf. Der Geber 40 überdeckt hierdurch die beiden Magnetfeldsensoren 24 und 28 ungleichmäßig und anders ausgedrückt, der Geber 40 beeinflusst die beiden Magnetfeldsensoren 34 und 38 unsymmetrisch. Vorliegend ist nur einer der beiden Magnetfeldsensoren 34 und 38 bedeckt.

In der Abbildung der Figur 11c ist eine Draufsicht auf die elfte erfindungsgemäße Ausführungsform in einer Ansicht in der X-Y-Ebene dargestellt. Im Folgenden werden nur die Unterschiede zu der Figur 11a und der Fig. 11b erläutert. Der Geber 40 bedeckt in der X-Y Ebene den Dauermagneten nur teilweise, vorzugsweise die Hälfte. Insbesondere ist nur einer der beiden Magnetfeldsensoren 34 und 38 bedeckt.

In Z-Richtung weist der Dauermagnet 20 anliegend an den Südpol 24 den Nordpol 28 auf. Nur der Südpol 24 weist zwei Schenkel 124 und einen dazwischen liegenden Bodenbereich 130 auf. Die Schenkel 124 des Südpols 124 sind zueinander entlang der Y-Achse parallel ausgebildet.

Beide Magnetfeldsensoren 34 und 38 sind im Bereich zwischen den beiden Schenkel 124 des Südpols 24 angeordnet. Der Halbleiterkörper 20 weist seine Längsachse entlang der X-Richtung auf und ist genau zentrisch oder nahezu zentrisch zwischen den Schenkeln 24 des Magneten 20 angeordnet. Die beiden entlang der Längsachse in der X-Richtung voneinander beabstandeten Magnetfeldsensoren 34 und 38 sind in Z-Richtung von dem Bodenbereich 130 beabstandet.
Die in der Z-Richtung ausgebildete Normale an der Stelle des Schwerpunkts des Dauermagneten 20 durchdringt ausgehend von der Mitte des Bodenbereichs 130 den Flächenschwerpunkt an der Oberfläche des Halbleiterkörpers 30 und halbiert hierdurch auch die gedachte Abstandsgerade zwischen den beiden Magnetfeldsensoren 34 und 38 an der Oberfläche des Halbleiterkörpers 20.

In einer nicht dargestellten Ausführungsform ist in dem zentralen Bodenbereich 130 ein viereckiges Loch 140 ausgebildet und enthält den Flächenmittelpunkt des Bodenbereichs 130.

Anders ausgedrückt, durchdringt in der nicht dargestellten Ausführungsform die in der Z-Richtung ausgebildete Normale an der Stelle des Schwerpunkts des Dauermagneten 20, ausgehend von der Mitte des Bodenbereichs 130 d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

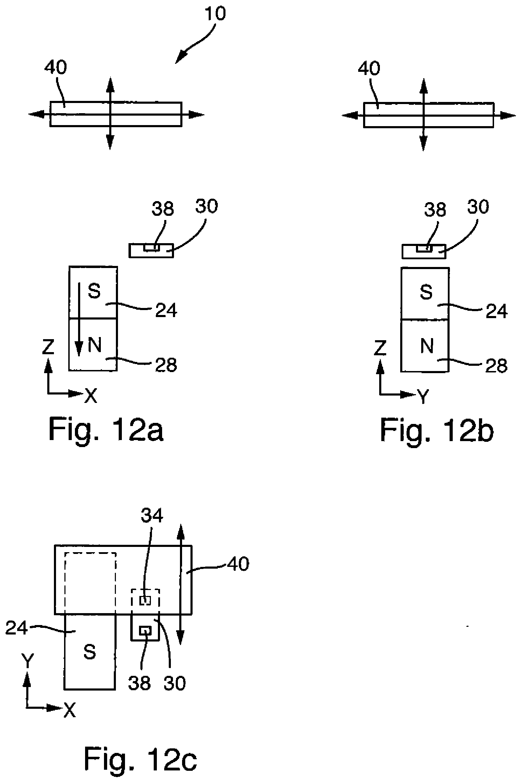

Die Abbildung der Figur 12a zeigt eine Draufsicht auf eine zwölfte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen Geber 40.

Der Geber 40 ist in allen Raumrichtungen verschiebbar und weist in der Y-Richtung vorzugsweise wenigstens die Ausdehnung des Dauermagneten 20 auf. Der Halbleiterkörper 30 weist eine integrierte Auswerteschaltung auf, welche vorliegend nicht dargestellt ist.

In Z-Richtung ist der Südpol 24 des Dauermagneten 20 auf dem Nordpol 28 angeordnet. Der Dauermagnet 20 weist eine vertikale oder eine in Z-Richtung verlaufende Magnetisierung auf.

Der erste Magnetfeldsensor 34 und der zweite Magnetfeldsensor 28 sind in Z-Richtung neben der oberen Kante des Südpols 24 angeordnet.

In der Abbildung der Figur 12b ist eine Draufsicht auf die zwölfte erfindungsgemäße Ausführungsform in einer Ansicht in der X-Z-Ebene dargestellt. Im Folgenden werden nur die Unterschiede zu der Figur 12a erläutert.

Die beiden Magnetfeldsensoren 34 und 38 sind entlang der in der X-Richtung ausgebildeten Längsachse des Halbleiterkörpers 20 voneinander beabstandet.

Die Längsachse des Halbleiterkörpers 30 ist entlang der X-Richtung ausgebildet und vorliegend ist nur die Kopfseite des Halbleiterkörpers 30 sichtbar. Der Geber 40 weist in der X-Richtung vorzugsweise eine vergleichbare oder größere Ausdehnung wie der Südpol 24 des Dauermagneten 20 auf.

In der Abbildung der Figur 12c ist eine Draufsicht auf die zwölfte erfindungsgemäße Ausführungsform in einer Ansicht in der X-Y-Ebene dargestellt. Im Folgenden werden nur die Unterschiede zu der Figur 12a und der Fig. 12b erläutert.

Der Geber 40 überdeckt die Oberseite des Südpols 24 nur etwa zur Hälfte und überdeckt nur einen der beiden neben dem Südpol 24 beabstandeten Magnetfeldsensoren 134 und 138 oder anders ausgedrückt, der Geber 40 beeinflusst die beiden Magnetfeldsensoren 34 und 38 unsymmetrisch.

Der Abstand zwischen dem Halbleiterkörper 30 und dem Südpol 24 ist in Y-Richtung parallel verlaufend gleichbleibend ausgebildet.

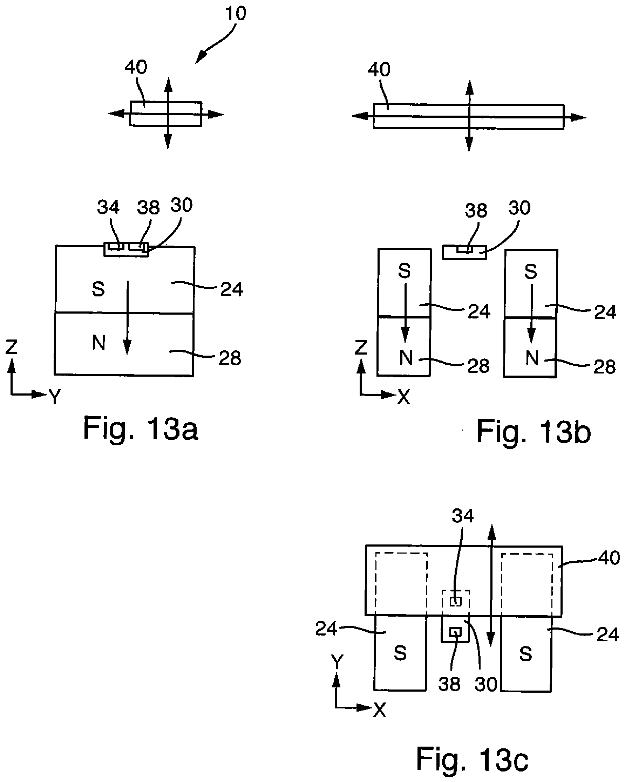

Die Abbildung der Figur 13a zeigt eine Draufsicht auf eine dreizehnte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen Geber 40.

Der Geber 40 ist in allen Raumrichtungen verschiebbar und weist in der Y-Richtung vorzugsweise nur eine etwa halb so große oder kleinere Ausdehnung wie der Dauermagnet 20 auf. Der Halbleiterkörper 30 weist eine integrierte Auswerteschaltung auf, welche vorliegend nicht dargestellt ist.

In Z-Richtung ist der Südpol 24 des Dauermagneten 20 auf dem Nordpol 28 angeordnet. Der Dauermagnet 20 weist eine vertikale oder eine in Z-Richtung verlaufende Magnetisierung auf.

Der erste Magnetfeldsensor 34 und der zweite Magnetfeldsensor 28 sind in Z-Richtung an der oberen Kante des Südpols 24 angeordnet.

In der Abbildung der Figur 13b ist eine Draufsicht auf die dreizehnte erfindungsgemäße Ausführungsform in einer Ansicht in der X-Z-Ebene dargestellt. Im Folgenden werden nur die Unterschiede zu der Figur 13a erläutert.

Der Dauermagnet 20 umfasst einem ersten Teil 21 und einen zweiten Teil 22. Der erste Teil 21 des Dauermagneten 20 und der zweite Teil 22 des Dauermagneten 20 weisen jeweils eine vertikale d.h. in Richtung der Z-Achse ausgebildete gleichsinnige Magnetisierung auf. Die beiden Magnetfeldsensoren 34 und 38 sind in der X-Richtung durch einen Spalt voneinander beabstandet.

Dei Größe des Spaltes ist wenigstens so groß wie die Breite des Halbleiterkörpers 30 an dessen Kopfseite. Die beiden Magnetfeldsensoren 34 und 38 sind entlang der in der Y-Richtung ausgebildeten Längsachse des Halbleiterkörpers 20 voneinander beabstandet.

Die Längsachse des Halbleiterkörpers 30 Ist entlang der Y-Richtung ausgebildet und vorliegend ist nur die Kopfseite des Halbleiterkörpers 30 sichtbar. Der Geber 40 weist in der X-Richtung vorzugsweise eine vergleichbare oder größere Ausdehnung wie die beiden Teil 21 und 22 des Dauermagneten 20 auf.

In der Abbildung der Figur 13c ist eine Draufsicht auf die dreizehnte erfindungsgemäße Ausführungsform in einer Ansicht in der X-Y-Ebene dargestellt. Im Folgenden werden nur die Unterschiede zu der Figur 13a und der Fig. 13b erläutert. Der Geber 40 überdeckt die Oberseite der beiden Südpole nur etwa zur Hälfte und überdeckt nur einen der beiden Magnetfeldsensoren 134 und 138 oder anders ausgedrückt, der Geber 40 beeinflusst die beiden Magnetfeldsensoren 34 und 38 unsymmetrisch.

Der Südpol 24 des ersten Teils 21 ist in geometrischer Hinsicht genau wie der Südpol 24 des zweiten Teils 22 ausgebildet. Die jeweils einander gegenüberliegenden Südpole 24 sind in Y-Richtung parallel verlaufend ausgebildet, d.h. der Spalt ist gleich breit.

Der erste Magnetfeldsensor 34 ist im Bereich zwischen den beiden Südpolen 24 angeordnet. Der Halbleiterkörper 20 ist genau zentrisch oder nahezu zentrisch zwischen den beiden Südpolen 24 der beiden Teile 21 und 22 des Dauermagneten 20 angeordnet.

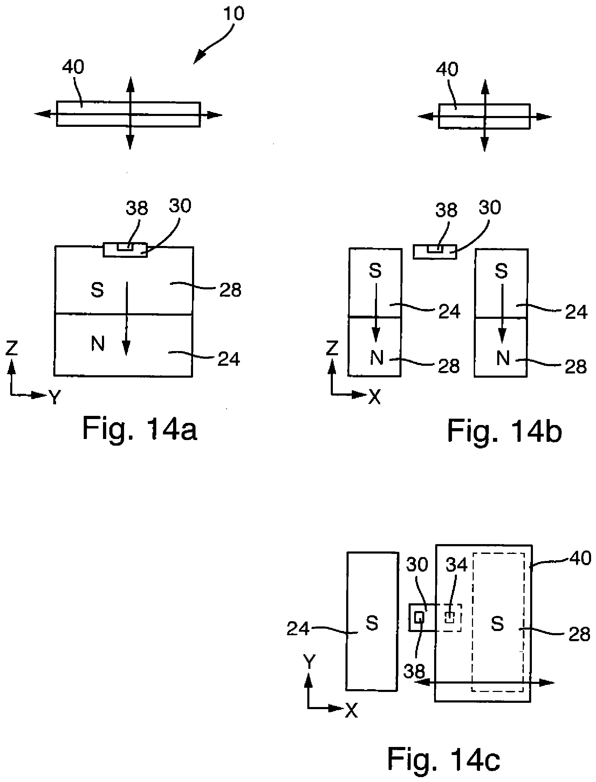

Die Abbildung der Figur 14a zeigt eine Draufsicht auf eine vierzehnte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen Geber 40.

Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist.

In Z-Richtung ist der Südpol 24 des Dauermagneten 20 auf dem Nordpol 28 angeordnet. Der Dauermagnet 20 weist eine vertikale oder eine in Z-Richtung verlaufende Magnetisierung auf.

Der erste Magnetfeldsensor 34 und der zweite Magnetfeldsensor 28 sind in Z-Richtung an der oberen Kante des Südpols 24 angeordnet.

In der Abbildung der Figur 14b ist eine Draufsicht auf die vierzehnte erfindungsgemäße Ausführungsform in einer Ansicht in der X-Z-Ebene dargestellt. Im Folgenden werden nur die Unterschiede zu der Figur 14a erläutert.

Der Dauermagnet 20 umfasst einem ersten Teil 21 und einen zweiten Teil 22. Der erste Teil 21 des Dauermagneten 20 und der zweite Teil 22 des Dauermagneten 20 weisen jeweils eine vertikale d.h. In Richtung der Z-Achse ausgebildete gleichsinnige Magnetisierung auf. Die beiden Magnetfeldsensoren 34 und 38 sind in der X-Richtung durch einen Spalt voneinander beabstandet.

Dei Größe des Spaltes ist wenigstens so groß wie die Länge des Halbleiterkörpers 30 in Richtung der Längsachse des Halbleiterkörpers 30 in X-Richtung. Die beiden Magnetfeldsensoren 34 und 38 sind entlang der in der X-Richtung ausgebildeten Längsachse des Halbleiterkörpers 20 voneinander beabstandet.

Die Längsachse des Halbleiterkörpers 30 ist entlang der Y-Richtung ausgebildet und vorliegend ist nur die Kopfseite des Halbleiterkörpers 30 sichtbar. Der Geber 40 weist in der X-Richtung vorzugsweise nur eine etwa halb so große oder kleinere Ausdehnung wie die beiden Teile 21 und 22 des Dauermagneten 20 auf.

In der Abbildung der Figur 14c ist eine Draufsicht auf die vierzehnte erfindungsgemäße Ausführungsform in einer Ansicht in der X-Y-Ebene dargestellt. Im Folgenden werden nur die Unterschiede zu der Figur 14a und der Fig. 14b erläutert.

Der Geber 40 überdeckt nur die Oberseite des Südpols des zweiten Teils 22 und überdeckt nur einen der beiden Magnetfeldsensoren 134 und 138 oder anders ausgedrückt, der Geber 40 beeinflusst die beiden Magnetfeldsensoren 34 und 38 unsymmetrisch.

Der Südpol 24 des ersten Teils 21 ist in geometrischer Hinsicht genau wie der Südpol 24 des zweiten Teils 22 ausgebildet. Die jeweils einander gegenüberliegenden Südpole 24 sind in Y-Richtung parallel verlaufend ausgebildet, d.h. der Spalt ist gleich breit.

Der Halbleiterkörper 20 ist genau zentrisch oder nahezu zentrisch zwischen den beiden Südpolen 24 den beiden Teile 21 und 22 des Dauermagneten 20 angeordnet.

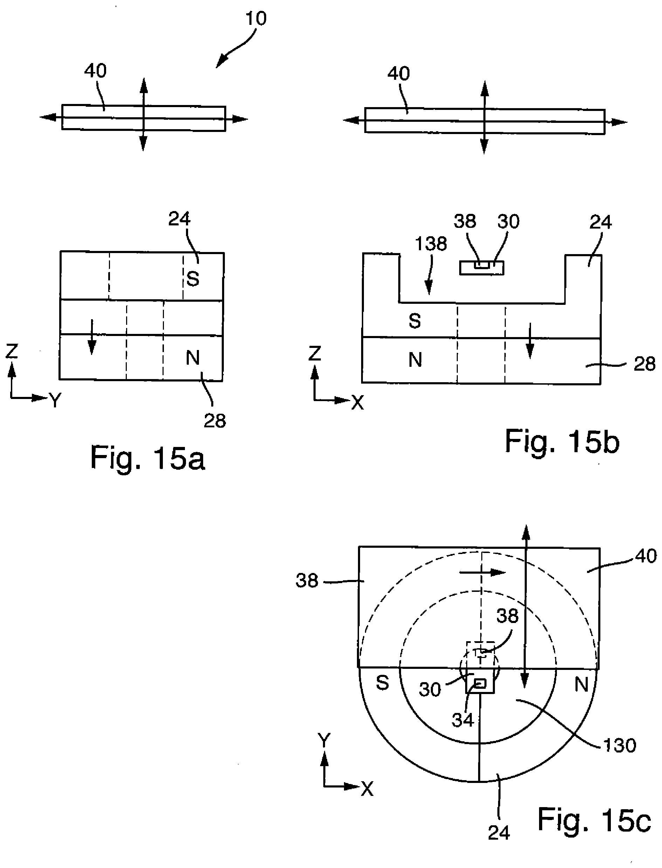

Die Abbildung der Figur 15a zeigt eine Draufsicht auf eine fünfzehnte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebendem Südpol 24 und einem in Z-Richtung oberhalb des Südpols 24 angeordneten Nordpols 28 und einen nicht dargestellten Halbleiterkörper 30 mit einem ersten monolithisch integrierten Magnetfeldsensor 34 und einem zweiten monolithisch integrierten Magnetfeldsensor 38 und einen ferromagnetischen plattenförmigen Geber 40.

Der Geber 40 ist In allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist. Vorliegend ist der erste Magnetfeldsensor 34 von dem zweiten Magnetfeldsensor 38 verdeckt. Der Dauermagnet 20 weist eine vertikale Magnetisierung. d.h. in Z-Richtung auf.

In der Abbildung der Figur 15b ist eine Draufsicht auf die fünfzehnte erfindungsgemäße Ausführungsform in einer Ansicht in der X-Z-Ebene dargestellt. Im Folgenden werden nur die Unterschiede zu der Figur 15a erläutert.

Der runde und topfartige ausgebildete Dauermagnet 20 weist einen in einer Y-X-Ebene umlaufenden Wall Schenkel 124 des Südpols 24 auf, wobei der Schenkel 124 als umlaufenden Wall kreisrund ausgebildet ist.

Zwischen dem umlaufenden Wall ist ein Bodenbereich 130 als Südpol 24 ausgebildet, anders ausgedrückt, die Polarität wechselt nur entlang der Z-Richtung.

Der Halbleiterkörper 30 weist eine Längsachse in Y-Richtung auf und ist in innerhalb des ringförmigen Walls, bestehend aus dem Schenkel 124 und in Z-Richtung gesehen oberhalb des Bodenbereichs 130, jedoch innerhalb der der in Z-Richtung ausgebildeten Höhe des Schenkels 124 angeordnet.

Der Halbleiterkörper 30 ist in Z-Richtung von dem Bodenbereich 130 beabstandet. Der Geber 40 weist auch in der X-Richtung vorzugsweise eine vergleichbare oder größere Ausdehnung wie der Dauermagnet 20 auf.

In der Mitte des Bodenbereichs 130 ist ein rundes Loch 140 ausgebildet.

In der Abbildung der Figur 15c ist eine Draufsicht auf die fünfzehnte erfindungsgemäße Ausführungsform in einer Ansicht in der X-Y-Ebene dargestellt. Im Folgenden werden nur die Unterschiede zu der Figur 15a und der Fig. 15b erläutert.

Der Geber 40 überdeckt den Dauermagneten 20 nur etwa zu Hälfte, d.h. auch die beiden Magnetfeldsensoren 24 und 28 werden ungleichmäßig bedeckt und anders ausgedrückt, die beiden Magnetfeldsensoren werden mittels des Gebers 40 unsymmetrisch beeinflusst.

Die beiden Magnetfeldsensoren 34 und 38 sind oberhalb des Bodenbereichs 130 angeordnet. Der Halbleiterkörper 20 ist genau zentrisch oder nahezu zentrisch zwischen dem umlaufenden Wall und in Z-Richtung von dem Bodenbereichs 130 beabstandet, angeordnet. Die beiden Magnetfeldsensoren 34 und 38 sind entlang der Längsachse des Halbleiterkörpers 20 in der Y-Richtung voneinander beabstandet.

In dem zentralen Bodenbereich 130 befindet sich auch der Schwerpunkt des Dauermagneten 20.

Der erste Magnetfeldsensor 34 ist in dem Bereich umgeben von dem u-förmigen Schenkel 124 des Südpols 24 und der zweite Magnetfeldsensor 38 ist in dem Bereich umgeben von dem u-förmigen Schenkel 128 des Nordpols 28 angeordnet. Der Halbleiterkörper 30 ist hierdurch in der Mitte von dem u-förmigen Schenkel 124 des Südpols 24 und u-förmigen Schenkel 128 des Nordpols 28 und in Z-Richtung mittig vorzugsweise genau mittig über dem Schwerpunkt angeordnet.

Da in dem zentralen Bodenbereich 130 das runde Loch 140 ausgebildet ist wird von dem Loch 140 auch der Schwerpunkt des Dauermagneten 20 umfasst.

Anders ausgedrückt, durchdringt die in der Z-Richtung ausgebildete Normale an der Stelle des Schwerpunkts des Dauermagneten 20 ausgehend von der Mitte des Bodenbereichs 130, d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

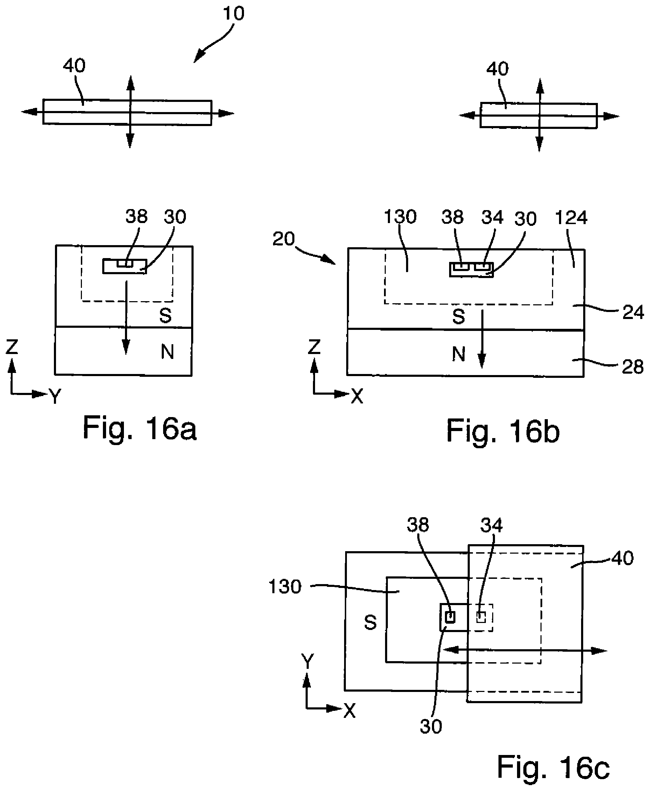

Die Abbildung der Figur 16a zeigt eine Draufsicht auf eine sechzehnte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebenden Nordpol 28 und Südpol 24 und einen Halbleiterkörper 30 mit einem ersten monolithisch integrierten Magnetfeldsensor 34 und einem zweiten monolithisch Integrierten Magnetfeldsensor 38 und einen ferromagnetischen plattenförmigen Geber 40.

Der Geber 40 ist in allen Raumrichtungen verschiebbar und weist in der Y-Richtung vorzugsweise eine vergleichbare oder größere Ausdehnung wie der Dauermagnet 20 auf. Der Halbleiterkörper 30 weist eine integrierte Auswerteschaltung auf, welche vorliegend nicht dargestellt ist. Vorliegend ist der erste Magnetfeldsensor 34 von dem zweiten Magnetfeldsensor 38 verdeckt.

Der Südpol 24 ist in Z-Richtung oberhalb des Nordpols 28 angeordnet, d.h. der Dauermagnet 20 weist eine vertikale Magnetisierung auf.

In der Abbildung der Figur 16b ist eine Draufsicht auf die sechzehnte erfindungsgemäße Ausführungsform in einer Ansicht in der X-Z-Ebene dargestellt. Im Folgenden werden nur die Unterschiede zu der Figur 16a erläutert.

Der viereckige und topfartige ausgebildete Dauermagnet 20 weist einen als umlaufenden Wall ausgebildeten Schenkel 124 des Südpols 24 auf. Innerhalb des umlaufenden Walls ist ein als Südpol 24 ausgebildeter Bodenbereich 130 ausgebildet, anders ausgedrückt, die Polarität wechselt nur entlang der Z-Achse.

Der Halbleiterkörper 30 weist eine Längsachse in X-Richtung auf und ist in etwa mittig zwischen dem Wall und in Z-Richtung gesehen oberhalb des Bodenbereichs 130, jedoch innerhalb der der in Z-Richtung ausgebildeten Höhe des Schenkels 124 angeordnet. Der Halbleiterkörper 30 ist in Z-Richtung von dem Bodenbereich 130 beabstandet. Der Geber 40 weist in der X-Richtung vorzugsweise nur etwa eine halb so große oder kleinere Ausdehnung wie der Dauermagnet 20 auf. Der Geber 40 überdeckt hierdurch die beiden Magnetfeldsensoren 24 und 28 ungleichmäßig und anders ausgedrückt, die beiden Magnetfeldsensoren werden mittels des Gebers 40 unsymmetrisch beeinflusst.

In einer nicht dargestellten Ausführungsform ist in der Mitte des Bodenbereichs 130 ein viereckiges Loch 140 ausgebildet.

In der Abbildung der Figur 16c ist eine Draufsicht auf die sechzehnte erfindungsgemäße Ausführungsform in einer Ansicht in der X-Y-Ebene dargestellt. Im Folgenden werden nur die Unterschiede zu der Figur 16a und der Fig. 16b erläutert. Der Geber 40 überdeckt nur den ersten Magnetfeldsensor 34 und den Dauermagneten 20 nur zur Hälfte.

Beide Magnetfeldsensoren 34 und 38 sind oberhalb des Bodenbereichs 130 angeordnet. Der Halbleiterkörper 20 ist genau zentrisch oder nahezu zentrisch zwischen dem umlaufenden Wall und in Z-Richtung von dem Bodenbereichs 130 beabstandet, angeordnet. Die beiden Magnetfeldsensoren 34 und 38 sind entlang der Längsachse des Halbleiterkörpers 20 in der X-Richtung voneinander beabstandet.

In dem zentralen Bodenbereich 130 befindet sich auch der Schwerpunkt des Dauermagneten 20.

Der Halbleiterkörper 30 ist in der Mitte von dem wallförmigen Schenkel 124 des Südpols 24 und in Z-Richtung mittig vorzugsweise genau mittig über dem Schwerpunkt angeordnet.

Anders ausgedrückt, durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

In einer nicht dargestellten Ausführungsform ist in dem zentralen Bodenbereich 130 das Loch 140 viereckig ausgebildet und enthält den Flächenmittelpunkt des Bodenbereichs 130.

Anders ausgedrückt, durchdringt in der nicht dargestellten Ausführungsform die in der Z-Richtung ausgebildete Normale an der Stelle des Schwerpunkts des Dauermagneten 20 ausgehend von der Mitte des Bodenbereichs 130, d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

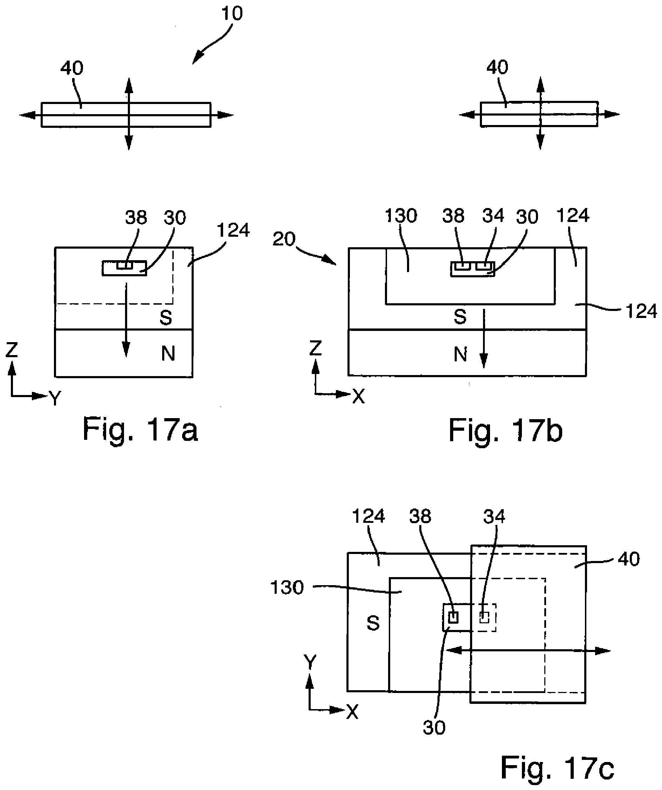

Die Abbildung der Figur 17a zeigt eine Draufsicht auf eine siebzehnte erfindungsgemäße Ausführungsform einer Abstandsmessvorrichtung 10 in einer Ansicht in der Y-Z-Ebene. Die Abstandsmessvorrichtung 10 umfasst einen Dauermagneten 20 mit einer Magnetisierungsrichtung entgegen Z-Richtung und sich daraus ergebenden Südpol 24 und Nordpol 28 und einen Halbleiterkörper 30 mit einem ersten monolithisch integrierten Magnetfeldsensor 34 und einem zweiten monolithisch integrierten Magnetfeldsensor 38 und einen ferromagnetischen plattenförmigen Geber 40.

Der Geber 40 ist in allen Raumrichtungen verschiebbar und weist in der Y-Richtung vorzugsweise etwa die gleiche oder eine größere Ausdehnung wie der Dauermagnet 20 auf. Der Halbleiterkörper 30 weist eine integrierte Auswerteschaltung auf, welche vorliegend nicht dargestellt ist. Vorliegend ist der erste Magnetfeldsensor 34 und von zweiten Magnetfeldsensor 38 in der X-Richtung beabstandet, d.h. der zweite Magnetfeldsensor 38 verdeckt den ersten Magnetfeldsensor 34.

Der Dauermagnet 20 weist eine in Z-Richtung ausgebildete vertikale Magnetisierung auf, wobei der Südpol 24 oberhalb des Nordpols 28 angeordnet ist.

In der Abbildung der Figur 17b ist eine Draufsicht auf die siebzehnte erfindungsgemäße Ausführungsform in einer Ansicht in der X-Z-Ebene dargestellt. Im Folgenden werden nur die Unterschiede zu der Figur 17a erläutert.

Der viereckige und nur teilweise in einer topfartigen Ausführung ausgebildete Dauermagnet 20 weist einen in der X-Y-Richtung ausgebildeten u-förmigen Schenkel 124 des Südpols 24 auf.

Zwischen den Seiten des u-förmigen Schenkel 124 des Südpols 24 ist ein Bodenbereich 130 als Südpol 24 ausgebildet, anders ausgedrückt, die Polarität wechselt nur entlang der Z-Richtung. Die Magnetisierung ist also vertikal in der Z-Richtung. Der durch den Schenkel 124 ausgebildeter Wall umschließt den Bodenbereich 130 nur an drei Seiten, d.h. der teilweise topfartig ausgeführte Dauermagnet 20 Ist Richtung der Y-Achse gesehen offen, d.h. entlang einer X-Z Ebene fehlt der umlaufende als Südpol 24 ausgebildete Wall.

Der Halbleiterkörper 30 weist eine Längsachse in X-Richtung auf und ist in etwa mittig zwischen dem aus dem u-förmigen Schenkel 124 gebildeten Bereich und in Z-Richtung gesehen oberhalb des Bodenbereichs 130, jedoch innerhalb der der in Z-Richtung ausgebildeten Höhe des Schenkels 124 angeordnet. Der Halbleiterkörper 30 ist in Z-Richtung von dem Bodenbereich 130 beabstandet. Der Geber 40 weist in der X-Richtung vorzugsweise nur eine etwa halb so große oder kleinere Ausdehnung wie der Dauermagnet 20 auf. Der Geber 40 überdeckt hierdurch die beiden Magnetfeldsensoren 24 und 28 ungleichmäßig oder anders ausgedrückt, die beiden Magnetfeldsensoren werden mittels des Gebers 40 unsymmetrisch beeinflusst.

In einer nicht dargestellten Ausführungsform ist in der Mitte des Bodenbereichs 130 ein viereckiges Loch 140 ausgebildet.

In der Abbildung der Figur 17c ist eine Draufsicht auf die siebzehnte erfindungsgemäße Ausführungsform in einer Ansicht in der X-Y-Ebene dargestellt. Im Folgenden werden nur die Unterschiede zu der Figur 17a und der Fig. 17b erläutert. Der Geber 40 bedeckt den Dauermagneten 20 und den Halbleiterkörper 30 nur teilweise.

Der u-förmige Schenkel 124 des Südpols 24 umschließt den Bodenbereich 130 nur an drei Seiten.

Beide Magnetfeldsensoren 34 und 38 sind entlang der Längsachse des Halbleiterkörpers 20 in der X-Richtung voneinander beabstandet und sind oberhalb des Bodenbereichs 130 des Südpols 24 angeordnet. Der Halbleiterkörper 20 ist exzentrisch, nahe an dem Wall entlang der X-Richtung abgeordnet. Der Halbleiterkörper 20 ist in Z-Richtung von dem Bodenbereichs 130 beabstandet angeordnet.

In dem zentralen Bodenbereich 130 befindet sich auch der Schwerpunkt des Dauermagneten 20.

Beide Magnetfeldsensor 34 und 38 sind in dem Bereich des u-förmigen Schenkel 124 des Südpols 24 angeordnet. Der Halbleiterkörper 30 ist in etwa in der Mitte von dem u-förmigen Schenkel 124 des Südpols 24 und in Z-Richtung mittig vorzugsweise genau mittig über dem Schwerpunkt angeordnet.

Anders ausgedrückt, durchdringt die in der Z-Richtung ausgebildete Normale an der Stelle des Schwerpunkts des Dauermagneten 20 ausgehend von der Mitte des Bodenbereichs 130 den Flächenschwerpunkt an der Oberfläche des Halbleiterkörpers 30 und halbiert hierdurch auch die in der Y-Richtung ausgebildete gedachte Abstandsgerade zwischen den beiden Magnetfeldsensoren 34 und 38 an der Oberfläche des Halbleiterkörpers 20.

In einer nicht dargestellten Ausführungsform ist in dem zentralen Bodenbereich 130 das Loch 140 viereckig ausgebildet und enthält den Flächenmittelpunkt des Bodenbereichs 130.

Anders ausgedrückt, durchdringt in der nicht dargestellten Ausführungsform die in der Z-Richtung ausgebildete Normale an der Stelle des Schwerpunkts des Dauermagneten 20 ausgehend von der Mitte des Bodenbereichs 130, d.h. an der Stelle an der das Loch 140 ausgebildet ist, den Flächenschwerpunkt an der Oberfläche des Halbleiterkörpers 30 und halbiert hierdurch auch die in der X-Richtung ausgebildete gedachte Abstandsgerade zwischen den beiden Magnetfeldsensoren 34 und 38 an der Oberfläche des Halbleiterkörpers 20.

## Patentansprüche

1. Abstandsmessvorrichtung (10) mit
einem ersten Magnetfeldsensor (34), wobei der erste Magnetfeldsensor (34) ein erstes Messsignal in Abhängigkeit der Stärke des Magnetfelds bereitstellt,
wenigstens einem Dauermagneten (20) mit einem ersten magnetischen Pol (24) mit einer ersten Polfläche und einem zweiten magnetischen Pol (28) mit einer zweiten Polfläche,
einem Halbleiterkörper (30) mit einer monolithisch integrierten Auswerteschaltung, wobei die Auswerteschaltung in einer elektrischen Wirkverbindung mit dem ersten Magnetfeldsensor (34) steht und der Halbleiterkörper (30) eine in der X-Y Ebene ausgebildete Oberfläche aufweist, einem auf dem gleichen physikalischen Wirkprinzip wie der erste Magnetfeldsensor (34) beruhenden zweiten Magnetfeldsensor (38), wobei der zweite Magnetfeldsensor (38) ein zweites Messsignal in Abhängigkeit der Stärke des Magnetfelds zur Verfügung stellt und der zweite Magnetfeldsensor (38) in einer Wirkverbindung mit der Auswerteschaltung steht und die Auswerteschaltung zur Unterdrückung von magnetischen Gleichfeldern ein Differenzsignal ermittelt und ein Ausgangssignal als Ergebnis der Ermittlung bereitstellt, wobei der Wert des auf der Aufhebung eines magnetflussfreien Bereichs beruhenden Ausgangssignals von einem Abstand eines ferromagnetischen Gebers (40) zu den beiden Magnetfeldsensoren abhängt und die beiden Magnetfeldsensoren kraftschlüssig der Oberfläche des Halbleiterkörpers verbunden sind und um die gleiche Komponente des Magnetfeldes zu messen, gleich angeordnet sind, wobei
um die Größe der Flussänderung bei dem auf beide Halbleitersensoren (34, 38) gleich stark einwirkenden ersten Geber zu messen, der Halbleiterkörper (30) zwischen u-förmig ausgebildeten Polschenkeln des in Y-Richtung magnetisierten Magneten angeordnet ist, wobei der erste Magnetfeldsensor (34) in einem zwischen zwei einander gegenüberliegenden Schenkeln (124, 128) des ersten pols^{liegenden} Gebiet angeordnet ist und der zweite Magnetfeldsensor (38) in einem zwischen zwei einander gegenüberliegenden Schenkeln (124, 128) des zweiten Pols liegenden Gebiet angeordnet ist, und zwischen den Polschenkeln (124, 128) eine Bodenfläche (130) ausgebildet ist und der Halbleiterkörper (30) in Z-Richtung oberhalb des Bodenbereichs (130) angeordnet ist.

2. Abstandsmessvorrichtung (10) nach Anspruch 1, **dadurch gekennzeichnet, dass** der Dauermagnet (20) u-förmig ausgebildet ist und zwei einander gegenüberliegende gerade und parallel verlaufende Schenkel (124, 128) oder kreisförmige Schenkel (124, 128) aufweisen.

3. Abstandsmessvorrichtung (10) nach Anspruch 1 oder Anspruch 2, **dadurch gekennzeichnet, dass** der Dauermagnet (20) in einem zentralen Bereich eine Aussparung (140) aufweist und die Aussparung (140) lochförmig ausgebildet ist.

4. Abstandsmessvorrichtung (10) nach Anspruch 3, **dadurch gekennzeichnet, dass** der zentrale Bereich den Schwerpunkt des Dauermagneten (20) umfasst.

5. Abstandsmessvorrichtung (10) nach einem oder mehreren der vorangegangenen Ansprüche, **dadurch gekennzeichnet, dass** der Halbleiterkörper (30) oberhalb des Schwerpunkts des Dauermagneten (20) angeordnet ist, so dass die an der Stelle des Schwerpunkts des Dauermagneten (20) ausgebildeten Normale den Halbleiterkörper (30) durchdringt.

6. Abstandsmessvorrichtung (10) nach einem oder mehreren der vorangegangenen Ansprüche, **dadurch gekennzeichnet, dass** der Dauermagnet (20) aus zwei entgegengesetzt unmittelbar nebeneinander angeordneten vertikal magnetisierten Einzelmagneten gebildet wird.

7. Abstandsmessvorrichtung (10) nach einem der vorstehenden Ansprüche, **dadurch gekennzeichnet, dass** zwischen den Schenkeln (124, 128) ein Bodenbereich (130) ausgebildet ist und entlang der Mittellinie im Bodenbereich (130) die Polarität des Dauermagneten (20) wechselt.

8. Abstandsmessvorrichtung (10) nach einem der vorstehenden Ansprüche, **dadurch gekennzeichnet, dass** die Schenkel (124, 128) in der X-Y-Ebene einen umlaufenden Wall ausbilden und eine erste Hälfte des Walls die erste magnetische Polarität (24) und eine zweite Hälfte des Walls die zweite Polarität (28) aufweist.

9. Abstandsmessvorrichtung (10) nach einem der vorstehenden Ansprüche, **dadurch gekennzeichnet, dass** in der X-Y-Ebene angeordnete Oberfläche der beiden Magnetfeldsensoren (34, 38) in Z-Richtung einen gleichen oder geringeren Abstand zu der inneren Bodenfläche (130) des Dauermagneten (20) aufweisen als die an den Enden der Schenkel (124, 128) ausgebildeten Polflächen.

10. Abstandsmessvorrichtung (10) nach einem der vorstehenden Ansprüche, **dadurch gekennzeichnet, dass** die beiden Magnetfeldsensoren (34, 38) zu der jeweiligen unmittelbar benachbarten Polfläche (124, 128) den gleichen Abstand aufweisen.

11. Abstandsmessvorrichtung (10) nach einem der vorstehenden Ansprüche, **dadurch gekennzeichnet, dass** die beiden Magnetfeldsensoren (34, 38) als Hallsensoren ausgebildet sind und die Hallsensoren monolithisch In den Halbleiterkörper integriert sind.

12. Abstandsmessvorrichtung (10) nach Anspruch 11, **dadurch gekennzeichnet, dass** die Hallsensoren als in der X-Y-Ebene ausgebildete Hallplatten ausgeführt sind.

## Claims

1. Distance measuring device (10) comprising
a first magnetic field sensor (34), wherein the first magnetic field sensor (34) provides a first measurement signal in dependence on the strength of the magnetic field,
at least one permanent magnet (20) with a first magnetic pole (24) with a first pole surface and a second magnetic pole (28) with a second pole surface,
a semiconductor body (30) with a monolithically integrated evaluating circuit, wherein the evaluating circuit is in electrically operative connection with the first magnetic field sensor (34) and the semiconductor body (30) has a surface formed in the X-Y plane,
a second magnetic field sensor (38) based on the same physical operative principle as the first magnetic field sensor (34), wherein the second magnetic field sensor (38) provides a second measurement signal in dependence on the strength of the magnetic field and the second magnetic field sensor (38) is in operative connection with the evaluating circuit and the evaluating circuit for suppression of magnetic constant fields determines a difference signal and provides an output signal as a result of the determination, wherein the value of the output signal based on neutralisation of a region free of magnetic flux depends on a spacing of a ferromagnetic transmitter (40) from the two magnetic field sensors and the two magnetic field sensors are connected with the surface of the semiconductor body by frictional couple and in order to measure the same component of the magnetic field have the same arrangement, wherein
in order to measure the magnitude of the flux change in the case of the first transmitter acting with the same strength on the two semiconductor sensors (34, 38) the semiconductor body (30) is arranged between U-shaped pole limbs of the magnet magnetised in Y direction, wherein the first magnet field sensor (34) is arranged in a region lying between two mutually opposite limbs (124, 128) of the first pole and the second magnetic field sensor (38) is arranged in a region lying between two mutually opposite limbs (124, 128) of the second pole, and a base area (130) is formed between the pole limbs (124, 128) and the semiconductor body (30) is arranged in Z direction above the base region (130).

2. Distance measuring device (10) according to claim 1, **characterised in that** the permanent magnet (20) is of U-shaped construction and has two mutually opposite straight and parallelly extending limbs (124, 128) or circular limbs (124, 128).

3. Distance measuring device (10) according to claim 1 or claim 2, **characterised in that** the permanent magnet (20) has a recess (140) in a central region and the recess (140) is formed to be apertured.

4. Distance measuring device (10) according to claim 3, **characterised in that** the central region embraces the centre of gravity of the permanent magnet (20).

5. Distance measuring device (10) according to one or more of the preceding claims, **characterised in that** the semiconductor body 930) is arranged above the centre of gravity of the permanent magnet (20) so that the normal formed at the location of the centre of gravity of the permanent magnet (20) passes through the semiconductor body (30).

6. Distance measuring device (10) according to one or more of the preceding claims, **characterised in that** the permanent magnet (20) is formed from two vertically magnetised individual magnets arranged in opposition directly adjacent to one another.

7. Distance measuring device (10) according to any one of the preceding claims, **characterised in that** a base region (130) is formed between the limbs (124, 128) and the polarity of the permanent magnet (20) changes along the centre line in the base region (130).

8. Distance measuring device (10) according to any one of the preceding claims, **characterised in that** the limbs (124, 128) form an encircling wall in the X-Y plane and a first half of the wall has the first magnet polarity (24) and a second half of the wall has the second polarity (28).

9. Distance measuring device (10) according to any one of the preceding claims, **characterised in that** in the surface arranged in the X-Y plane the two magnetic field sensors (34, 38) have in the Z direction a spacing from the inner base surface (130) of the permanent magnet (20) which is the same as or smaller than the pole surfaces at the ends of the limbs (124, 128).

10. Distance measuring device (10) according to any one of the preceding claims, **characterised in that** the two magnetic field sensors (34, 38) have the same spacing from the respective directly adjacent pole surface (124, 128).

11. Distance measuring device (10) according to any one of the preceding claims, **characterised in that** the two magnetic field sensors (34, 38) are constructed as Hall sensors and the Hall sensors are monolithically integrated in the semiconductor body.

12. Distance measuring device (10) according to claim 11, **characterised in that** the Hall sensors are executed as Hall plates constructed in the X-Y plane.

## Revendications

1. Dispositif de mesure de distance (10), comprenant :
un premier détecteur de champ magnétique (34), dans lequel le premier détecteur de champ magnétique (34) délivre un premier signal de mesure en fonction de l'intensité du champ magnétique,
au moins un aimant permanent (20) comprenant un premier pôle magnétique (24) qui présente une première face polaire et comprenant un deuxième pôle magnétique (28) qui présente une seconde face polaire,
un corps à semi-conducteur (30) comprenant un circuit d'évaluation intégré de façon monolithique, dans lequel le circuit d'évaluation se trouve dans une liaison électrique active avec le premier détecteur de champ magnétique (34) et le corps à semi-conducteur (30) présente une surface formée dans le plan X-Y, et
un deuxième détecteur de champ magnétique (38) qui est basé sur le même principe actif physique que le premier détecteur de champ magnétique (34), dans lequel le deuxième détecteur de champ magnétique (38) délivre un deuxième signal de mesure en fonction de l'intensité du champ magnétique, et le deuxième détecteur de champ magnétique (38) se trouve dans une liaison active avec le circuit d'évaluation et le circuit d'évaluation détermine un signal différentiel pour supprimer des champs magnétiques identiques et délivre un signal de sortie comme résultat de la détermination, dans lequel la valeur du signal de sortie basé sur la suppression d'une zone dépourvue de flux magnétique dépend d'une distance entre un capteur ferromagnétique (40) et les deux détecteurs de champ magnétique, et les deux détecteurs de champ magnétique sont attachés par adhérence à la surface du corps à semi-conducteur et sont disposés de manière identique de manière à mesurer la même composante du champ magnétique,
dans lequel, pour mesurer la grandeur de la variation de flux dans le premier capteur qui agit avec la même intensité sur les deux corps à semi-conducteur (34, 38), le corps à semi-conducteur (30) est disposé entre des branches polaires réalisées en forme de U de l'aimant magnétisé dans la direction Y,
dans lequel le premier détecteur de champ magnétique (34) est disposé dans une zone qui est située entre deux branches opposées l'une à l'autre (124, 128) du premier pôle, et le deuxième détecteur de champ magnétique (38) est disposé dans une zone qui est située entre deux branches opposées l'une à l'autre (124, 128) du deuxième pôle, et une face de fond (130) est formée entre les branches polaires opposées l'une à l'autre (124, 128), et le corps à semi-conducteur (30) est disposé dans la direction Z au-dessus de la zone de fond (130).

2. Dispositif de mesure de distance (10) selon la revendication 1, **caractérisé en ce que** l'aimant permanent (20) est réalisé en forme de U et présente deux branches rectilignes opposées l'une à l'autre et qui s'étendent parallèlement l'une à l'autre (124, 128), ou deux branches circulaires (124, 128).

3. Dispositif de mesure de distance (10) selon la revendication 1 ou la revendication 2, **caractérisé en ce que** l'aimant permanent (20) comporte une découpe (140) dans une région centrale, et la découpe (140) est réalisée en forme de trou.

4. Dispositif de mesure de distance (10) selon la revendication 3, **caractérisé en ce que** la zone centrale comprend le centre de gravité de l'aimant permanent (20).

5. Dispositif de mesure de distance (10) selon une ou plusieurs des revendications précédentes, **caractérisé en ce que** le corps à semi-conducteur (30) est disposé au-dessus du centre de gravité de l'aimant permanent (20), de telle manière que la normale formée à l'endroit du centre de gravité de l'aimant permanent (20) transperce le corps à semi-conducteur (30).

6. Dispositif de mesure de distance (10) selon une ou plusieurs des revendications précédentes, **caractérisé en ce que** l'aimant permanent (20) est constitué de deux aimants individuels magnétisés verticalement qui sont disposés directement l'un à côté de l'autre en position opposée.

7. Dispositif de mesure de distance (10) selon l'une quelconque des revendications précédentes, **caractérisé en ce qu'**une zone de fond (130) est formée entre les branches (124, 128), et la polarité de l'aimant permanent 20) alterne le long de la ligne centrale dans la zone de fond (130).

8. Dispositif de mesure de distance (10) selon l'une quelconque des revendications précédentes, **caractérisé en ce que** les branches (124, 128) forment un mur périphérique dans le plan X-Y, et une première moitié du mur présente la première polarité magnétique (24) et la seconde moitié du mur présente la seconde polarité (28).

9. Dispositif de mesure de distance (10) selon l'une quelconque des revendications précédentes, **caractérisé en ce que** la surface des deux détecteurs de champ magnétique (34, 38) disposée dans le plan X-Y présente dans la direction Z une distance jusqu'à la face de fond intérieure (130) de l'aimant permanent (20) qui est égale ou inférieure à la distance jusqu'aux faces polaires formées aux extrémités des branches (124, 128).

10. Dispositif de mesure de distance (10) selon l'une quelconque des revendications précédentes, **caractérisé en ce que** les deux détecteurs de champ magnétique (34, 38) sont situés à la même distance de la face polaire directement voisine respective (124, 128).

11. Dispositif de mesure de distance (10) selon l'une quelconque des revendications précédentes, **caractérisé en ce que** les deux détecteurs de champ magnétique (34, 38) sont formés par des capteurs de Hall, et les capteurs de Hall sont intégrés de façon monolithique dans le corps à semi-conducteur.

12. Dispositif de mesure de distance (10) selon la revendication 11, **caractérisé en ce que** les capteurs de Hall sont réalisés sous la forme de plaques de Hall réalisées dans le plan X-Y.
